# EUROPEAN PATENT APPLICATION

(11) **EP 4 727 269 A1**
(43) Date of publication of application: **15.04.2026**
(21) Application number: 25726007.5
(22) Date of filing: 19.05.2025
(51) Int. Cl.: H05K 1/14

(54) **ELECTRONIC DEVICE COMPRISING FPCB ASSEMBLY**

(30) Priority: 20.08.2024 KR 20240111637; 02.10.2024 KR 20240134348
(71) Applicant: Samsung Electronics Co., Ltd, Suwon-si, Gyeonggi-do 16677 (KR)
(72) Inventor: LEE, Seungchul, Suwon-si, Gyeonggi-do 16677 (KR); SONG, Seongjun, Suwon-si, Gyeonggi-do 16677 (KR); CHO, Sujeong, Suwon-si, Gyeonggi-do 16677 (KR); KANG, Hyunggwang, Suwon-si, Gyeonggi-do 16677 (KR); LEE, Jungwoo, Suwon-si, Gyeonggi-do 16677 (KR)
(74) Representative: HGF
(86) International application number: PCT/KR2025/006796
(87) International publication number: WO 2026/043011

(57) **Abstract**

An electronic device includes a housing including a first housing part and a second housing part, a first printed circuit board (PCB), a second PCB, and a flexible printed circuit board (FPCB) assembly. The FPCB assembly includes a first PCB where a first set of signal lines is formed, a second PCB where a second set of signal lines is formed, and at least one link part rotatably connecting the first PCB and the second PCB. The at least one link part includes a first sub link part and a second sub link part rotatably coupled to each other.

## Description

### [Technical Field]

The present disclosure relates to an electronic device including a flexible printed circuit board assembly.

### [Background Art]

An electronic device may include a plurality of housing parts that are movably coupled. For example, the electronic device may include a first housing part and a second housing part movably coupled to the first housing part. In terms of the first housing part and the second housing part being movably coupled, the electronic device may be referred to as a rollable device or a sliding device. When the first housing part or the second housing part moves, a distance between components disposed in the first housing part and components disposed in the second housing part may change.

The above-described information may be provided as a related art for the purpose of helping to understand the present disclosure. No claim or determination is raised as to whether any of the above-described information may be applied as a prior art related to the present disclosure.

### [Disclosure]

### [Technical Solution]

An electronic device is provided. The electronic device may comprise a housing including a first housing part and a second housing part movably coupled to each other, a first printed circuit board, PCB, disposed in the first housing part, a second PCB disposed in the second housing part, and a flexible printed circuit board, FPCB, assembly configured to electrically connect the first PCB and the second PCB. Wherein the FPCB assembly may include a first PCB comprising a first set of signal lines for transmitting a plurality of signals, a second PCB comprising a second set of signal lines for transmitting the plurality of signals, and at least one link part rotatably connecting the first PCB and the second PCB. Wherein the at least one link part may comprise a first sub link part and a second sub link part rotatably coupled to each other. Wherein the first sub link part may comprise a first set of conductive patterns, each conductive pattern of the first set of conductive patterns electrically connected to a respective signal line of the first set of signal lines. Wherein the second sub link part may comprise a second set of conductive patterns, each conductive pattern of the second set of conductive patterns electrically connected to a respective signal line of the second set of signal lines. Wherein each conductive pattern of the first set of conductive patterns is configured to be electrically connected to a respective conductive pattern of the second set of conductive patterns.

An electronic device is provided. The electronic device may comprise a housing including a first housing part and a second housing part movably coupled to each other. The electronic device may comprise a first printed circuit board (PCB) disposed in the first housing. The electronic device may comprise a second PCB disposed in the second housing. The electronic device may comprise a flexible printed circuit board (FPCB) assembly configured to electrically connecting the first PCB and the second PCB. The FPCB assembly may include a first PCB where a first set of signal lines transmitting a plurality of signals are formed, a second PCB where a second set of signal lines transmitting the plurality of signals are formed, and at least one link part rotatably connecting the first PCB of the FPCB assembly and the second PCB of the FPCB assembly. The at least one link part may include a first sub link part and a second sub link part rotatably coupled each other. The first sub link part may include a first set of conductive patterns electrically connected to the first set of signal lines respectively. The second sub link part may include a second set of conductive patterns electrically connected to the second set of signal lines respectively. Each conductive pattern of the first set of conductive patterns and each conductive pattern of the second set of conductive patterns may be configured to be electrically connected each other. An electrical connection between each conductive pattern of the first set of conductive patterns and each conductive pattern of the second set of conductive patterns may be also configured to be maintained, while at least one of the first sub link part and the second sub link part rotates.

An electronic device is provided. The electronic device may comprise a housing including a first housing part, and a second housing part movably coupled to the first housing part. The electronic device may comprise a flexible display configured to at least partially be bent based on movement of the second housing part with respect to the first housing part. The electronic device may comprise a first printed circuit board (PCB) disposed in the first housing part. The electronic device may comprise a second PCB disposed in the second housing. The electronic device may comprise a flexible printed circuit board (FPCB) assembly configured to electrically connecting the first PCB and the second PCB. The FPCB assembly may includes a first PCB, a second PCB, and one or more link parts rotatably connecting the first PCB of the FPCB assembly and the second PCB of the FPCB assembly. Each of the one or more link parts may include a first sub link part, connected to the first PCB of the FPCB assembly, including a first set of conductive patterns, a second sub link part, rotatably coupled to the first sub link part, connected to the second PCB of the FPCB assembly, and including a second set of conductive patterns electrically connected to a corresponding conductive pattern of the first set of conductive patterns respectively. The first sub link part and the second sub link part may be configured to rotate the first PCB of the FPCB assembly and the second PCB of the FPCB assembly by rotating in accordance with the movement of the second housing part.

### [Description of the Drawings]

FIG. 1 is a block diagram of an electronic device in a network environment according to an embodiment.
FIG. 2A is a front view of an electronic device in a first state, according to an embodiment.
FIG. 2B is a rear view of an electronic device in a first state, according to an embodiment.
FIG. 3A is a front view of an electronic device in a second state, according to an embodiment.
FIG. 3B is a rear view of an electronic device in a second state, according to an embodiment.
FIG. 4 is an exploded perspective view of an electronic device, according to an embodiment.
FIG. 5 is a block diagram of an electronic device, according to an embodiment.
FIG. 6 illustrates an interior of an electronic device in a first state, according to an embodiment.
FIG. 7 is an exploded perspective view of some components of an electronic device, according to an embodiment.
FIG. 8 illustrates an interior of an electronic device in a second state, according to an embodiment.
FIG. 9A illustrates a flexible printed circuit board (FPCB) assembly when an electronic device is in a first state.
FIG. 9B illustrates a flexible printed circuit board (FPCB) assembly when an electronic device is in a second state.
FIG. 10 illustrates a first sub link part.
FIG. 11 illustrates a second sub link part.
FIG. 12 illustrates a first sub link part and a second sub link part coupled with each other in a first state of an electronic device.
FIG. 13 illustrates a first sub link part and a second sub link part coupled with each other in a second state of an electronic device.
FIGS. 14 and 15 illustrate an example of cross sections of a first sub link part and a second sub link part.
FIG. 16 is a side view of a X portion of FIG. 8.
FIG. 17 illustrates an example of a flexible printed circuit board (FPCB) assembly.
FIG. 18 illustrates an electronic device including a guide groove according to an embodiment.
FIG. 19 is an enlarged view of a Y portion of FIG. 18.
FIG. 20 is an enlarged view of a Z portion of FIG. 19.
FIG. 21 illustrates a portion of a first sub link part and a second sub link part.
FIG. 22A illustrates a first sub link part and a second sub link part, according to an embodiment.
FIG. 22B illustrates a portion of a first sub link part and a second sub link part.
FIG. 23 illustrates an electronic device according to an embodiment.

### [Mode for Invention]

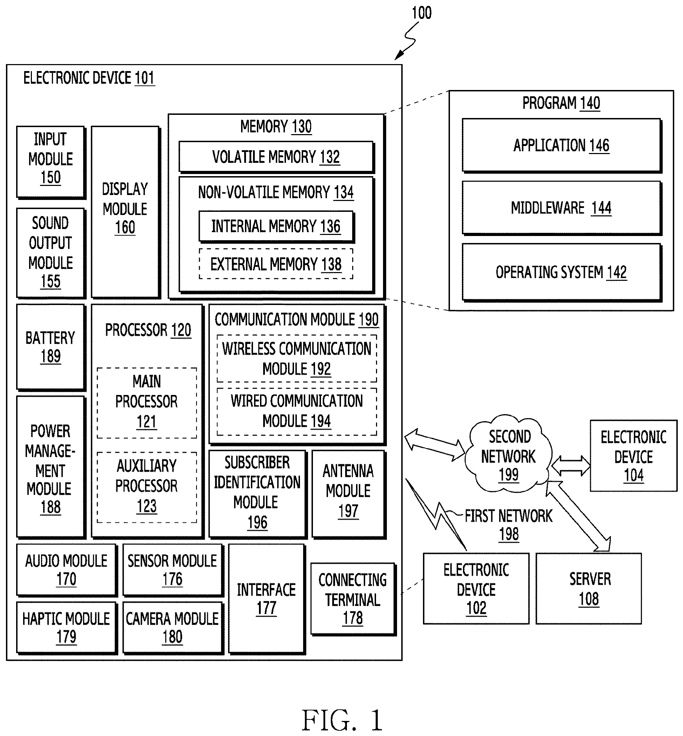

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function.

The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

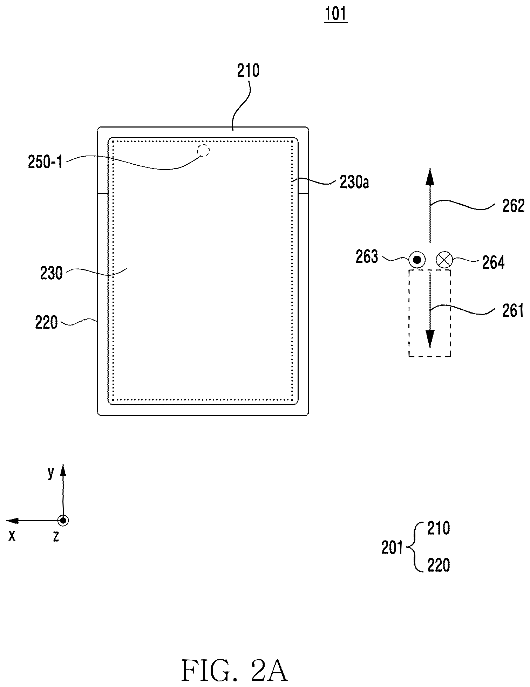

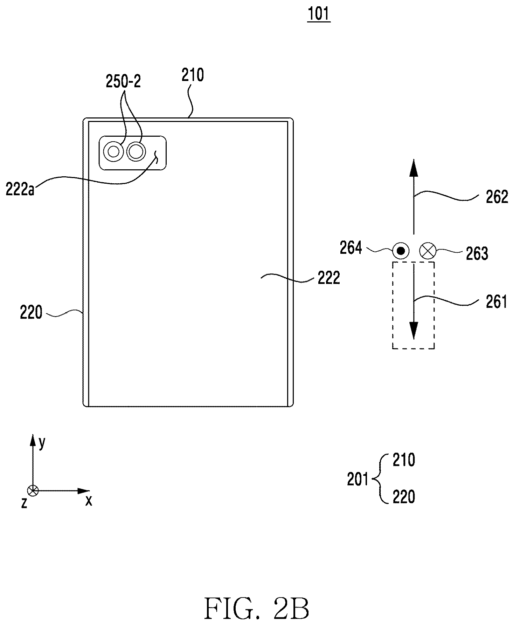

A display of the display module 160 may be flexible. The display may include a display region exposed to the outside of a housing (e.g., the housing 201 of FIG. 2A) of the electronic device 101 that provides at least a portion of an outer surface of the electronic device 101. Since the display has flexibility, at least a portion of the display may be rollable into the housing or slidable into the housing. A size of the display region may be changed according to a size of at least a portion of the display rolled into the housing or slid into the housing. For example, the electronic device 101 including the display may be within a plurality of states (that is, may be provided in, or may comprise, a plurality of states) including a first state providing the display region having a first size and a second state providing the display region having a second size different from the first size. For example, the first state may be exemplified through the description of FIGS. 2A and 2B.

FIG. 2A is a front view of an electronic device according to an embodiment in a first state.

Referring to FIG. 2A, an electronic device 101 may include a housing 201 and a flexible display 230 (e.g., the display module 160 of FIG. 1). For example, the housing 201 may include a first housing part 210 and a second housing part 220 movably coupled to the first housing part 210. For example, the second housing part 220 may be movable with respect to the first housing part 210 in a first direction 261 parallel to y-axis or a second direction 262 parallel to the y-axis and opposite to the first direction 261.

In the present disclosure, it is described that the second housing part 220 is moved with respect to the first housing part 210, but embodiments of the present disclosure are not limited thereto. For example, the housing 201 may have a structure in which the overall size of the housing 201 may be changed according to a change in a relative positional relationship between the first housing part 210 and the second housing part 220. The relative positional relationship between the first housing part 210 and the second housing part 220 may be changed by an operation of a driving mechanism to be described later. For example, the first housing part 210 may be movable with respect to the second housing part 220, by the driving mechanism. For example, both the first housing part 210 and the second housing part 220 may be movable by the driving mechanism.

According to an embodiment, the electronic device 101 may be in a first state. In the first state, the second housing part 220 may be movable with respect to the first housing part 210 in the first direction 261 among the first direction 261 and the second direction 262. For example, in the first state, the second housing part 220 may not be substantially movable in the second direction 262 with respect to the first housing part 210. The first direction 261 may be referred to as a direction in which the second housing part 220 moves away from the first housing part 210. The first direction 261 may be referred to as the -y direction of FIG. 2A. The second direction 262 may be referred to as a direction in which the second housing part 220 approaches the first housing part 210. The second direction 262 may be referred to as the +y direction of FIG. 2A.

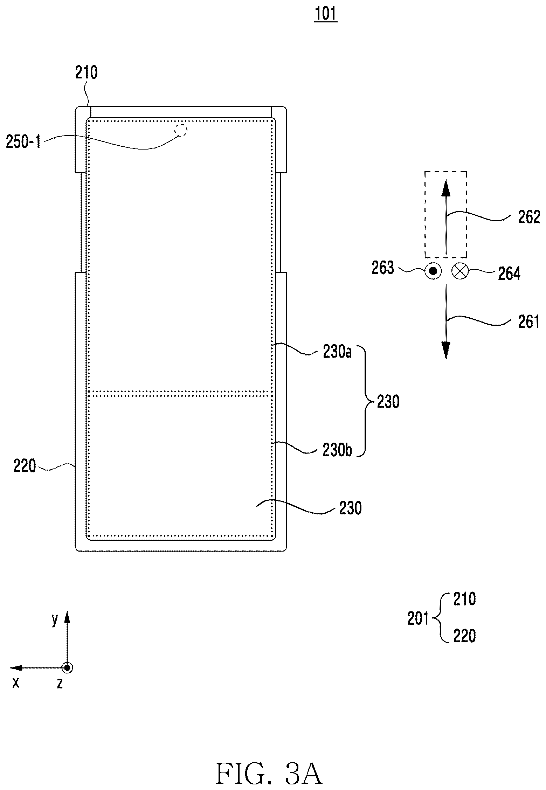

According to an embodiment, in the first state, the flexible display 230 may provide a display region having the smallest size. For example, in the first state, the display region may correspond to a first region 230a. Although not illustrated in FIG. 2A, in the first state, a second region (e.g., a second region 230b of FIG. 3A) of the flexible display 230 different from the first region 230a that is the display region may be included in the first housing part 210. In the first state, the second region 230b may be covered by the first housing part 210. In the first state, the second region 230b may be rolled into the first housing part 210.

The first state may be referred to as a slide-in state or a closed state. For example, in terms of providing a display region having the smallest size, the first state may be referred to as a reduced state. However, it is not limited thereto.

The first housing part 210 may include a first image sensor 250-1 in a camera module (e.g., the camera module 180 of FIG. 1), exposed through a portion of the first region 230a and directed in a third direction 263 parallel to the z-axis. Although not illustrated in FIG. 2A, the first housing part 210 may include one or more second image sensors in the camera module 180 exposed through a portion of the first housing part 210 and directed in a fourth direction 264 parallel to the z-axis and opposite to the third direction 263. For example, the one or more second image sensors may be illustrated through the description of FIG. 2B.

FIG. 2B is a rear view of an electronic device in a first state, according to an embodiment.

Referring to FIG. 2B, in the first state, the one or more second image sensors 250-2 disposed in the first housing part 210 may be located within a structure disposed in the second housing part 220. For example, in the first state, light from the outside of the electronic device 101 may be received by the one or more second image sensors 250-2 through the structure. Since the one or more second image sensors 250-2 are located within the structure in the first state, the one or more second image sensors 250-2 may be exposed through the structure in the first state. For example, the structure may be implemented in various ways. For example, the structure may be an opening or a notch. For example, the structure may be an opening 222a in a rear plate 222 of the second housing part 220 surrounding at least a portion of the first housing part 210. However, it is not limited thereto.

The first state may be changed to a second state. The first state (or the second state) may be changed to the second state (or the first state) through intermediate states (e.g. one or more intermediate states) between the first state and the second state.

For example, the first state (or the second state) may be changed to the second state (or the first state) based on a user input. For example, the first state (or the second state) may be changed to the second state (or the first state), in response to a user input to a physical button exposed through a portion of the first housing part 210 or a portion of the second housing part 220. For example, the first state (or the second state) may be changed to the second state (or the first state), in response to a touch input to an executable object displayed in a display region. For example, the first state (or the second state) may be changed to the second state (or the first state), in response to a touch input having a contact point on a display region and a pressing strength greater than or equal to a reference strength. For example, the first state (or the second state) may be changed to the second state (or the first state), in response to a voice input received through a microphone of the electronic device 101. For example, the first state (or the second state) may be changed to the second state (or the first state), in response to a force applied to the first housing part 210 and/or the second housing part 220 to move the second housing part 220 with respect to the first housing part 210. For example, the first state (or the second state) may be changed to the second state (or the first state), in response to a user input identified in an external electronic device (e.g., earbuds or smart watch) connected to the electronic device 101. However, it is not limited thereto.

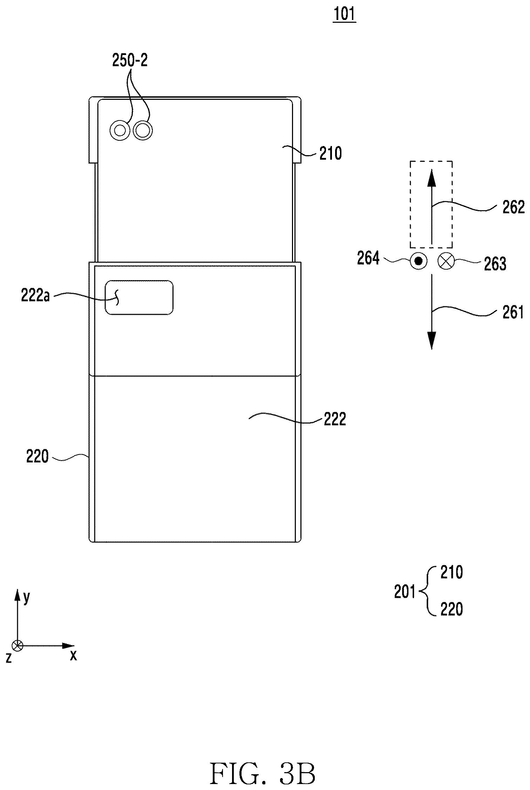

The second state may be exemplified through the description of FIGS. 3A and 3B.

FIG. 3A is a front view of an electronic device in a second state, according to an embodiment.

Referring to FIG. 3A, the electronic device 101 may be in the second state. For example, in the second state, the second housing part 220 may be movable with respect to the first housing part 210 in the second direction 262 among the first direction 261 and the second direction 262. For example, in the second state, the second housing part 220 may not be substantially movable in the first direction 261 with respect to the first housing part 210. That is, the second housing part 220 may be fully extended (slid out, rolled out) in the first direction 261 in respect of the first housing part 210.

According to this configuration, in the second state, the flexible display 230 may provide a display region having the largest size. For example, in the second state, the display region may include a first region 230a and a second region 230b. At least a portion of the second region 230b of the display region, which was disposed inside the first housing part 210 in the first state (and therefore not exposed to the outside when in the first state), may be exposed in the second state.

The second state may be referred to as a slide-out state or an opened state in that a size of the display region of the flexible display 230 exposed to the outside of the first housing part 210 and the second housing part 220 increases due to movement of the first housing part 210 or the second housing part 220. For example, the second state may be referred to as an extended state in terms of providing the display region having the largest size. However, it is not limited thereto.

When a state of the electronic device 101 is changed from the first state to the second state, the first image sensor 250-1 facing the third direction 263 may be moved together with the first region 230a, according to movement of the second housing part 220 in the first direction 261 or movement of the first housing part 210 in the second direction 262. Although not illustrated in FIG. 3A, when the state of the electronic device 101 is changed from the first state to the second state, one or more second image sensors (e.g., the one or more second image sensors 250-2 of FIG. 3B) facing the fourth direction 264 may be moved according to the movement of the second housing part 220 in the first direction 261 or the movement of the first housing part 210 in the second direction 262. For example, the relative positional relationship between the one or more second image sensors 250-2 and the structure exemplified in the description of FIG. 2B may be changed according to the movement of the one or more second image sensors 250-2. For example, the change in the relative positional relationship may be exemplified through FIG. 3B.

FIG. 3B is a rear view of an electronic device in a second state, according to an embodiment.

Referring to FIG. 3B, in the second state, the one or more second image sensors 250-2 may be located outside the structure. For example, in the second state, the one or more second image sensors 250-2 may be located outside the opening 222a in the second plate 222. As described with reference to FIG. 2B, the one or more second image sensors 250-2 may be exposed through the opening 222a in the first state. Since the one or more second image sensors 250-2 are located outside the first housing part 210 in the second state, the one or more second image sensors 250-2 may be exposed in the second state. Since the one or more second image sensors 250-2 are located outside the structure in the second state, the relative positional relationship in the second state may be different from the relative positional relationship in the first state.

For example, in a case that the electronic device 101 does not include the structure such as the opening 222a, the one or more second image sensors 250-2 may be exposed in the second state among the first state and the second state.

Although not illustrated in FIGS. 2A, 2B, 3A, and 3B, the electronic device 101 may be in an intermediate state between the first state and the second state. For example, a size of the display region in the intermediate state may be larger than a size of the display region in the first state and smaller than a size of the display region in the second state. For example, the display region in the intermediate state may correspond to a region including a portion of the first region 230a and the second region 230b. For example, in the intermediate state, a portion of the second region 230b may be exposed, and another portion (or remaining portion) of the second region 230b may be covered by the first housing part 210 or rolled into the first housing part 210. However, it is not limited thereto.

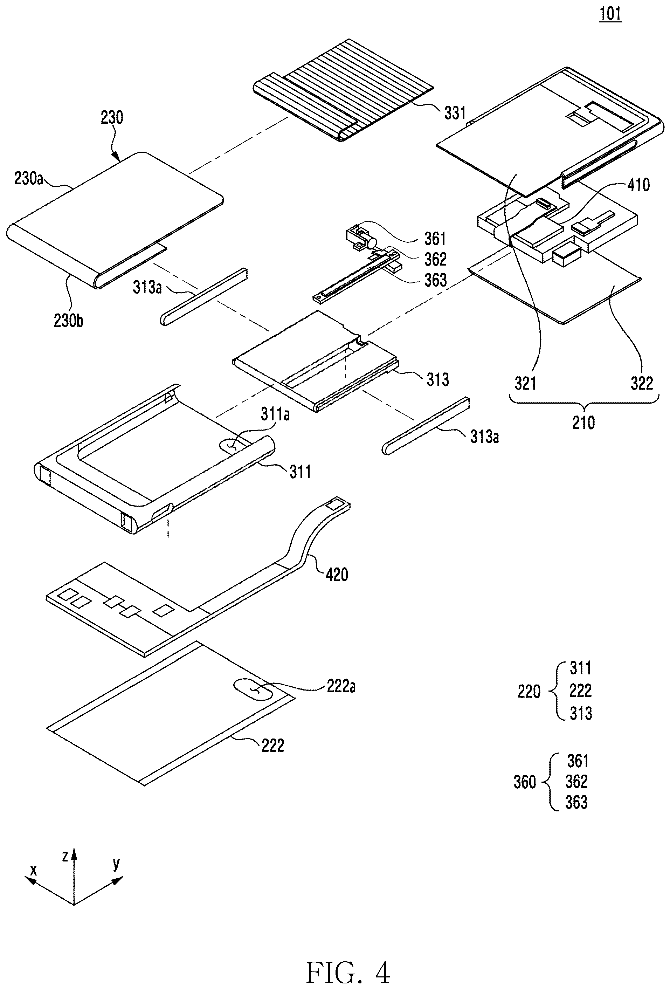

FIG. 4 is an exploded perspective view of an electronic device, according to an embodiment.

Referring to FIG. 4, an electronic device 101 may include a first housing part 210, a second housing part 220, a flexible display 230, and a driving mechanism 360.

According to an embodiment, the first housing part 210 may include a first bracket 321 and a first plate 322.

According to an embodiment, the first bracket 321 may be at least partially surrounded by the flexible display 230. For example, the first bracket 321 may support at least a portion of a first display region 230a of the flexible display 230 surrounding the first bracket 321. The first bracket 321 may support at least one component of the electronic device 101.

According to an embodiment, the first bracket 321 may be coupled to the first plate 322. For example, the first plate 322 may be coupled with the first bracket 321 to protect at least one component of the electronic device 101 coupled with the first bracket 321 and/or at least one structure of the electronic device 101 coupled with the first bracket 321. The first PCB 410 may be disposed between the first bracket 321 and the first plate 322.

According to an embodiment, the second housing part 220 may include a second bracket 311, a second plate 222, and a frame 313.

According to an embodiment, the second bracket 311 may at least partially form an outer surface of the electronic device 101. For example, the second bracket 311 may include an opening 311a for the one or more second image sensors 250-2. The second bracket 311 may include a surface supporting the second plate 222. The second bracket 311 may be coupled to the second plate 222. The second PCB 420 may be disposed between the second bracket 311 and the second plate 222.

According to an embodiment, the second plate 222 may at least partially form a rear portion of the outer surface. For example, the second plate 222 may include an opening 222a for the one or more second image sensors 250-2. The second plate 222 may be disposed on the surface of the second bracket 311. The opening 222a may be aligned with the opening 311a.

According to an embodiment, the frame 313 may be at least partially surrounded by the second bracket 311. For example, the frame 313 may be at least partially surrounded by the flexible display 230. The frame 313 may be arranged in relation to at least a portion of components of the flexible display 230. For example, the frame 313 may include rails 313a that provide (or guide) a path for movement of at least one component of the flexible display 230. For example, the frame 313 may be coupled with at least one structure of the electronic device 101 for a plurality of states including the first state and the second state. For example, the frame 313 may fasten a motor 361 of the driving mechanism 360.

According to an embodiment, the electronic device 101 may include a support member 331 for supporting at least a portion of the flexible display 230. For example, the support member 331 may include a plurality of bars. For example, the plurality of bars may be coupled to each other. The support member 331 may support the second display region 230b of the flexible display 230.

According to an embodiment, the driving mechanism 360 may include a motor 361, a pinion gear 362, and a rack gear 363.

The motor 361 may operate based on power from a battery. For example, the power may be provided to the motor 361 in response to a user input.

The pinion gear 362 may be coupled to the motor 361 through a shaft. For example, the pinion gear 362 may be rotated based on the operation of the motor 361 transmitted through the shaft.

The rack gear 363 may be arranged in relation to the pinion gear 362. For example, teeth of the rack gear 363 may be engaged with teeth of the pinion gear 362. The rack gear 363 may move in a first direction (e.g., -y direction) or a second direction (e.g., +y direction), according to a rotation of the pinion gear 362. For example, the rack gear 363 may be coupled to the first housing part 210 or the second housing part 220. For example, the second housing part 220 may be moved in the first direction and the second direction with respect to the first housing part 210, by the rack gear 363 moved according to the rotation of the pinion gear 362 due to the operation of the motor 361. For example, the first state of the electronic device 101 may be changed to a state (e.g., the one or more intermediate states or the second state) different from the first state through the movement of the second housing part 220 in the first direction. For example, the second state of the electronic device 101 may be changed to a state (e.g., the one or more intermediate states or the first state) different from the second state through the movement of the second housing part 220 in the second direction.

The electronic device described below may be referred to as the electronic device 101 described with reference to FIGS. 2A, 2B, 3A, 3B, and 4. The same reference numerals are given to the same components as the above-described components, and overlapping descriptions may be omitted.

In the present disclosure, terms such as "above", "below", "an end portion," and "another end portion" should be understood as terms indicating a relative positional relationship rather than terms indicating an absolute positional relationship, and terms specified for convenience of explanation. For example, when the electronic device illustrated in the drawing is flipped, "above" and "below" may be switched.

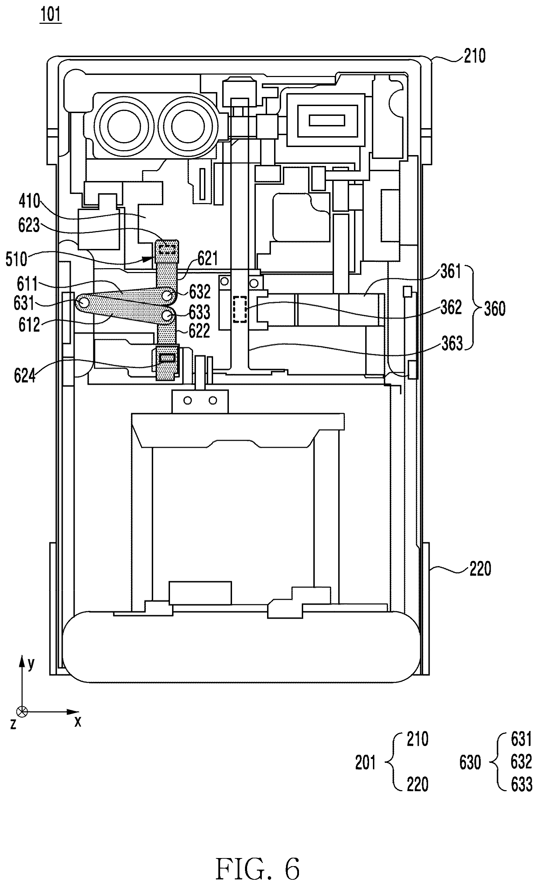

In the present disclosure, a housing (e.g., the housing 201 of FIG. 6) of an electronic device (e.g., the electronic device 101 of FIG. 6) may include a first housing part (e.g., the first housing part 210 of FIG. 6) and a second housing part (e.g., the second housing part 220 of FIG. 6) movably coupled to each other. In the following description, it may be described that the second housing part is moved with respect to the first housing part, but embodiments of the present disclosure are not limited to a structure in which the first housing part is fixed and the second housing part is movable. As described above, a relative positional relationship between the first housing part and the second housing part may be changed. For example, the first housing part may be movable with respect to the second housing part, or both the first housing part and the second housing part may be movable.

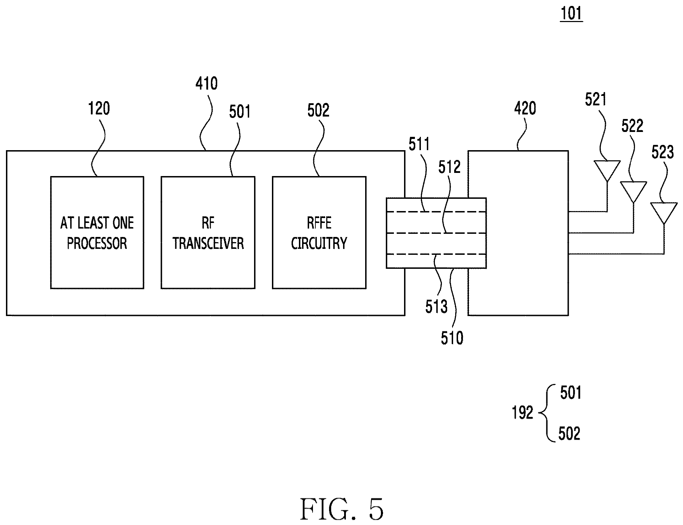

FIG. 5 is a block diagram of an electronic device (e.g. according to any of the preceding Figures), according to an embodiment.

Referring to FIG. 5, an electronic device 101 according to an embodiment may include at least one processor (e.g., the processor 120 of FIG. 1). The at least one processor 120 may include processing circuitry. The at least one processor 120 may include an application processor (AP) (e.g., a central processing unit (CPU)) and/or a communication processor (CP) (e.g., a modem), but it is not limited thereto. The at least one processor 120 may include a graphics processing unit (e.g., a GPU), a neural processing unit (NPU) (e.g., an artificial intelligence (AI) chip), a wireless-fidelity (Wi-Fi) chip, a Bluetooth^{™} chip, a global positioning system (GPS) chip, a near field communication (NFC) chip, connectivity chips, a sensor controller, a touch controller, a finger-print sensor controller, a display drive integrated circuit (DDI), an audio CODEC chip, a universal serial bus (USB) controller, a camera controller, an image processing IC, a microprocessor unit (MPU), a system on chip (SoC), an IC, or a similar circuit.

According to an embodiment, the electronic device 101 may include wireless communication circuitry (e.g., the wireless communication module 192 of FIG. 1). The wireless communication circuitry 192 may include a radio frequency (RF) frequency transceiver 501 and an RF front end (RFFE) circuitry 502.

According to an embodiment, the at least one processor 120 may generate a baseband signal. The at least one processor 120 may control the RF transceiver 501 to process the generated baseband signal. The at least one processor 120 may control the RF transceiver 501 so that a transmission signal is transmitted through one or more antenna radiators (e.g., a first antenna radiator 521, a second antenna radiator 522, and/or a third antenna radiator 523). The at least one processor 120 may control the RF transceiver 501 so that the transmission signal is transmitted in a frequency band capable of communicating with an external electronic device.

According to an embodiment, the RF transceiver 501 may be implemented as a single chip (e.g., an RFIC chip) or as a portion of a single package. The RF transceiver 501 may include a digital to analog converter (DAC) for converting a digital signal into an analog signal. The RF transceiver 501 may include a mixer and an oscillator (e.g., local oscillator (LO)) for up-conversion. The RF transceiver 501 may convert a baseband signal generated by the at least one processor 120 into an RF signal. The RF transceiver 501 may include an analog to digital converter (ADC) for converting an analog signal into a digital signal. The RF transceiver 501 may include a mixer and an oscillator for down-conversion. The RF transceiver 501 may convert an RF signal received from one or more antenna radiators into a baseband signal so that it may be processed by the at least one processor 120.

According to an embodiment, the RFFE circuitry 502 may include a plurality of components electrically connected between the RF transceiver 501 and one or more antenna radiators. For example, the RFFE circuitry 502 may include components such as a coupler, a power amplifier (PA), a low noise amplifier (LNA), a switch circuit, and/or a duplexer, but it is not limited thereto.

According to an embodiment, the wireless communication circuitry 192 may be configured to communicate with an external electronic device using one or more antenna radiators. According to an embodiment, the one or more antenna radiators may include a feeding point at which a feeding signal from the wireless communication circuitry 192 is provided, and a ground point connected to a ground of the electronic device 101.

According to an embodiment, the electronic device 101 may include a first PCB 410 and/or a second PCB 420. The first PCB 410 and the second PCB 420 may include a plurality of conductive layers and a plurality of non-conductive layers stacked alternately with the plurality of conductive layers. The first PCB 410 and the second PCB 420 may provide an electrical connection between various electronic components, by using wirings and conductive vias formed in the plurality of conductive layers.

According to an embodiment, the first PCB 410 may be disposed in a first housing part (e.g., the first housing part 210 of FIG. 6), and the second PCB 420 may be disposed in a second housing part (e.g., the second housing part 220 of FIG. 6). For example, the first PCB 410 may be referred to as a main PCB, and the second PCB 420 may be referred to as a sub-PCB. For example, the at least one processor 120 and the wireless communication circuitry 192 may be disposed on the first PCB 410, which is the main PCB. The second PCB 420 may be electrically connected to one or more antenna radiators. In FIG. 5, one or more antenna radiators are illustrated to be electrically connected to the second PCB 420, but the electronic device 101 may further include other antenna radiators electrically connected to the first PCB 410.

An antenna radiator, which is a physical component of an antenna, may be configured to be fed from wireless communication circuitry (e.g., the wireless communication module 192 of FIG. 1) and radiate and/or receive electromagnetic waves. One or more antenna radiators may be configured to radiate RF signals to the outside of the electronic device 101, based on feeding from the wireless communication circuitry 192. A type and performance of an antenna may be based on a physical structure of the antenna radiator.

One or more antenna radiators may be provided as a plurality of radiators. Each of the antenna radiators may have different frequency characteristics. For example, according to an electrical length of each of the antenna radiators, a resonant frequency of RF signals transmitted and/or received through each of the antenna radiators may be different. The electronic device 101 may include antenna radiators that transmit and/or receive RF signals on different frequency bands to transmit and/or receive various RF signals. For example, the first antenna radiator 521 may be configured to transmit and/or receive a first RF signal on a first frequency band. For example, the second antenna radiator 522 may be configured to transmit and/or receive a second RF signal on a second frequency band. For example, the third antenna radiator 523 may be configured to transmit and/or receive a third RF signal on a third frequency band. The electronic device 101 may perform a multiple-input and multiple-output (MIMO) operation using antenna radiators.

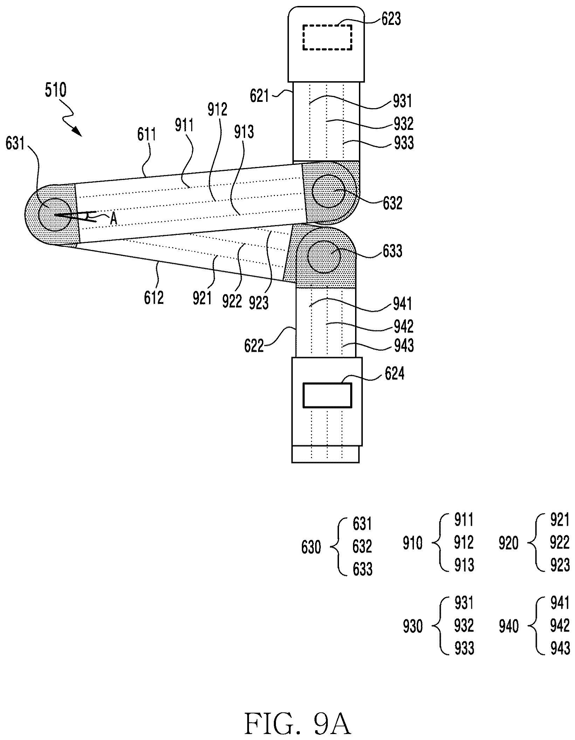

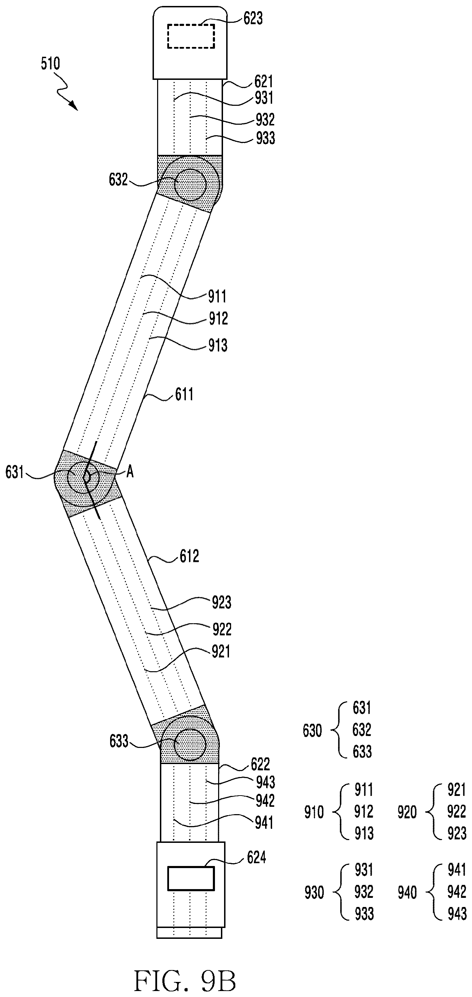

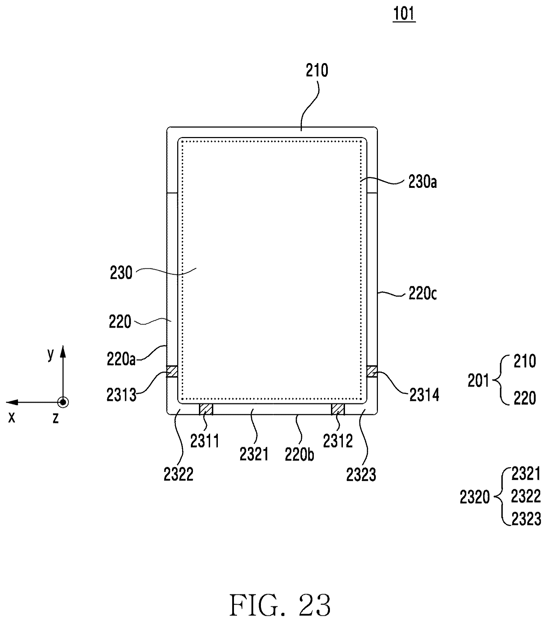

According to an embodiment, since the wireless communication circuitry 192 is disposed on the first PCB 410, and the antenna radiators are electrically connected to the second PCB 420, an electrical connection between the first PCB 410 and the second PCB 420 may be required to electrically connect the wireless communication circuitry 192 and the antenna radiators. According to an embodiment, the electronic device 101 may include an flexible printed circuit board (FPCB) assembly 510 configured to electrically connect the first PCB 410 and the second PCB 420. For example, the FPCB assembly 510 may include a signal line 511 for transmitting the first RF signal between the first PCB 410 and the second PCB 420, a signal line 512 for transmitting the second RF signal between the first PCB 410 and the second PCB 420, and/or a signal line 513 for transmitting the third RF signal between the first PCB 410 and the second PCB 420. However, it is not limited thereto. The signal lines 511, 512, and 513 may include signal lines to be described below with reference to FIGS. 9A and 9B. One or more antenna radiators may be implemented as a portion (e.g., peripheral portions 1321, 1322, and 1323 of FIG. 23) of the second housing part 220.

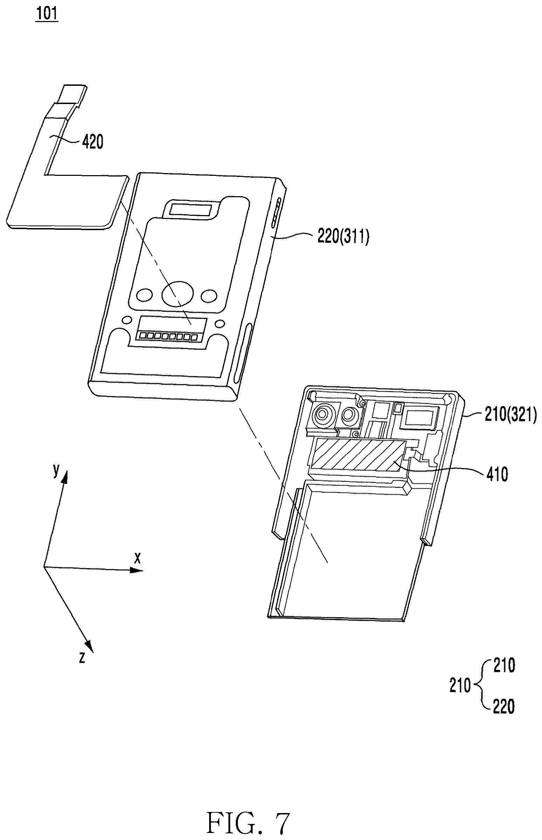

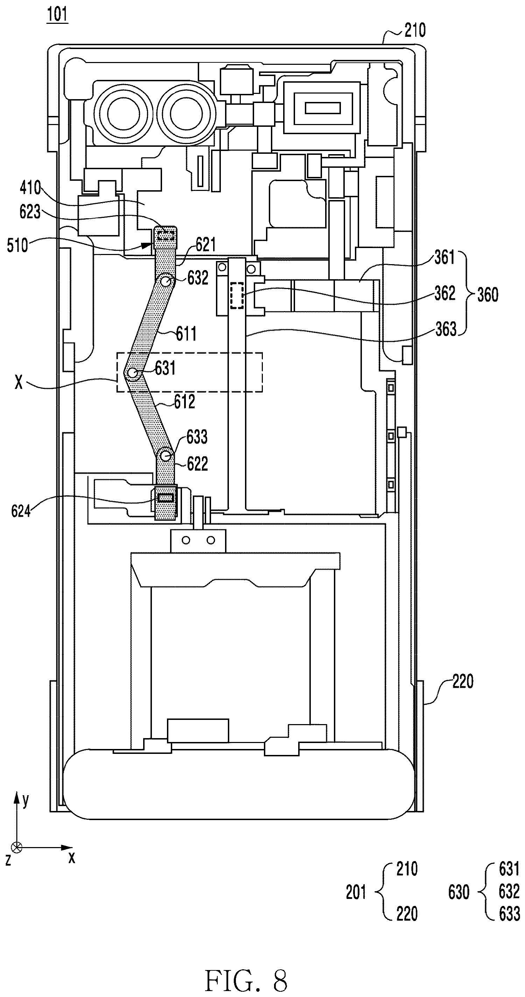

FIG. 6 illustrates an interior of an electronic device in a first state, according to an embodiment. FIG. 7 is an exploded perspective view of some components of an electronic device, according to an embodiment. FIG. 8 illustrates an interior of an electronic device in a second state, according to an embodiment.

Referring to FIG. 6, an electronic device 101 may include a housing 201 including a first housing part 210 and a second housing part 220. The second housing part 220 may be movably coupled to the first housing part 210. For example, the second housing part 220 may be movable in a first direction (e.g., -y direction) or a second direction (e.g., +y direction) with respect to the first housing part 210. The first direction or the second direction may be a direction parallel to the y-axis of FIG. 5. The first direction and the second direction may be defined according to a coupling relationship between the first housing part 210 and the second housing part 220, and are not limited to the above-described examples. For example, the first direction and the second direction may be parallel to the x-axis.

In the present disclosure, a first state may be referred to as a state in which the second housing part 220 is movable in the first direction among the first direction or the second direction with respect to the first housing part 210, and the second state may be referred to as a state in which the second housing part 220 is movable in the second direction among the first direction or the second direction with respect to the first housing part 210. The first direction may be referred to as a direction in which a side of the second housing part 220 moves away from the first housing part 210. The second direction may be referred to as a direction in which the side of the second housing part 220 approaches the first housing part 210.

According to an embodiment, the electronic device 101 may include a driving mechanism 360. For example, the driving mechanism 360 may include a motor 361, a pinion gear 362, and a rack gear 363.

According to one configuration, the motor 361 may operate based on power provided from a battery (e.g., the battery 189 of FIG. 1). The power may be provided to the motor 361 in response to a user input. According to an embodiment, the pinion gear 362 may be coupled to a rotation shaft of the motor 361. When the power is supplied from the battery to the motor 361, the pinion gear 362 may be rotated around the rotation shaft of the motor 361.

According to an embodiment, the rack gear 363 may be coupled to the second housing part 220. The rack gear 363 may extend parallel to a moving direction of the second housing part 220. For example, the rack gear 363 may extend to be parallel to the first direction and the second direction. The first direction and the second direction may correspond to the y-axis of FIG. 6. The rack gear 363 may linearly move in the first direction or the second direction. The rack gear 363 may be engaged with the pinion gear 362. When the pinion gear 362 is rotated by the motor 361, the rack gear 363 may be moved in the first direction or the second direction, based on a rotation of the pinion gear 362.

According to an embodiment, the electronic device 101 may include a first PCB 410 and a second PCB (e.g., a second PCB 420 of FIG. 7). Referring to FIG. 7, the first PCB 410 may be disposed in the first housing part 210, and the second PCB 420 may be disposed in the second housing part 220. For example, the first PCB 410 may be disposed on a first bracket 321 of the first housing part 210. For example, the second PCB 420 may be disposed on a second bracket 311 of the second housing part 220. Although not illustrated in FIG. 7, the first PCB 410 may be covered by a first plate (e.g., the first plate 322 of FIG. 4) of the first housing part 210, and the second PCB 420 may be covered by a second plate (e.g., the second plate 222 of FIG. 4) of the second housing part 220.

Since the first PCB 410 is disposed in the first housing part 210, and the second PCB 420 is disposed in the second housing part 220, the first PCB 410 and the second PCB 420 may be spaced apart from each other. Since the first PCB 410 and the second PCB 420 are disposed to be spaced apart from each other, the electronic device 101 may include an FPCB assembly (e.g., the FPCB assembly of FIG. 6) for an electrical connection between the first PCB 410 and the second PCB 420.

Referring to FIGS. 6 and 8, the FPCB assembly 510 may be connected to each of the first PCB 410 and the second PCB 420 to electrically connect the first PCB 410 and the second PCB 420. For example, the FPCB assembly 510 may be directly connected to each of the first PCB 410 and the second PCB 420 or may also be electrically connected to each of the first PCB 410 and the second PCB 420 through another PCB. The FPCB assembly 510 may be configured to transmit an electrical signal (e.g., RF signal or control signal) between the first PCB 410 and the second PCB 420 by electrically connecting the first PCB 410 and the second PCB 420.

For example, an electronic component (e.g., the wireless communication circuitry of FIG. 5) electrically connected to the first PCB 410 may be electrically connected to an electronic component (e.g., the first antenna radiator 521, the second antenna radiator 522, and/or the third antenna radiator 523 of FIG. 5) electrically connected to the second PCB 420 through the FPCB assembly 510. In terms of electrically connecting the first PCB 410 and the second PCB 420 spaced apart from each other and transmitting an electrical signal, the FPCB assembly 510 may be referred to (e.g. alternatively referred to) as a connecting member, a connection structure, a connection assembly, a third PCB, a wire, a transmission member, and a cable.

According to an embodiment, the electronic device 101 may include wireless communication circuitry (e.g., the wireless communication module 192 of FIG. 1) for communication with an external electronic device, and antenna radiators. For example, the wireless communication circuitry 192 may be disposed on the first PCB 410, and at least one antenna radiator (e.g., the first antenna radiator 521, the second antenna radiator 522, and/or the third antenna radiator 523 of FIG. 5) among the antenna radiators may be electrically connected to the second PCB 420. The wireless communication circuitry 192 may be configured to transmit RF signals to an external electronic device, by feeding power to the at least one antenna radiator through the first PCB 410, the FPCB assembly 510, and the second PCB 420. For example, the wireless communication circuitry 192 may be configured to receive RF signals received through the at least one antenna radiator from the external electronic device, through the second PCB 420, the FPCB assembly 510, and the first PCB 410.

For example, the electronic device 101 may include at least one processor (e.g., the processor 120 of FIG. 1) and an electronic component including circuitry configured to be controlled by the at least one processor 120. The at least one processor 120 may be disposed on the first PCB 410, and the electronic component including the circuitry may be disposed on the second PCB 420. The at least one processor 120 may be configured to provide, to the circuitry through the first PCB 410, the FPCB assembly 510, and the second PCB 420, a control signal for controlling an electronic component. The circuitry may be configured to operate the electronic component, based on the control signal provided from the at least one processor 120.

According to an embodiment, as the second housing part 220 moves with respect to the first housing part 210, a distance between the first PCB 410 and the second PCB 420 may be changed. For example, when a state of the electronic device 101 is the first state illustrated in FIG. 6, a distance between the first PCB 410 and the second PCB 420 may be relatively close. As the second housing part 220 moves in the first direction away from the first housing part 210, the state of the electronic device 101 may be changed to the second state of the electronic device 101 illustrated in FIG. 8. For example, when the state of the electronic device 101 is the second state illustrated in FIG. 8, the distance between the first PCB 410 and the second PCB 420 may be relatively far.

As the electronic device 101 is changed from the first state to the second state, the distance between the first PCB 410 and the second PCB 420 may increase. As the electronic device 101 is changed from the second state to the first state, the distance may be reduced. Since the distance is changed according to the state of the electronic device 101, an arrangement of the FPCB assembly 510 electrically connecting the first PCB 410 and the second PCB 420 may be changed according to the change of the distance.

If the FPCB assembly has flexibility, at least a portion of the FPCB assembly may be flexible. At least a portion of the FPCB assembly may include a flexible portion capable of being bent or unfolded according to the change in the distance between the first PCB 410 and the second PCB 420. The flexible portion may cause loss of electrical signals (e.g., RF signal) transmitted through the FPCB assembly. When the flexible portion is bent, deterioration of a radiation characteristic (e.g., S-parameter) of an antenna in accordance with a change in the impedance of a transmission line may be caused.

According to an embodiment, the FPCB assembly 510 may include a plurality of segments that are rotatably connected in conjunction with movement of the second housing part 220 with respect to the first housing part 210. The plurality of segments may be rotatably connected to each other. When the distance between the first PCB 410 and the second PCB 420 is changed by the movement of the second housing part 220 with respect to the first housing part 210, an arrangement relationship of the plurality of segments may be changed by rotating the plurality of segments. The plurality of segments may not be flexible and may be rigid. That is, in examples, each of the plurality of segments may be rigid. In a case that a plurality of segments is rigid, since only the arrangement relationship between the plurality of segments is changed according to the change of the distance and a shape is not bent or unfolded, loss of electrical signals and/or impedance change may be reduced.

Referring to FIGS. 6 and 8, the FPCB assembly 510 may include a first PCB 611 (e.g. a first assembly PCB) and a second PCB 612 (e.g. a second assembly PCB ).. The first PCB 611 of the FPCB assembly 510 and the second PCB 612 of the FPCB assembly 510 may be termed as segments, or parts, of the FPCB assembly 510. The first PCB 611 of the FPCB assembly 510 and the second PCB 612 of the FPCB assembly 510 may be rotatably coupled to each other. For example, an end portion (e.g. a first end portion) of the first PCB 611 of the FPCB assembly 510 may be rotatably coupled to an end portion (e.g. a first end portion) of the second PCB 612 of the FPCB assembly 510. When the distance between the first PCB 410 and the second PCB 420 is changed, as the first PCB 611 of the FPCB assembly 510 and the second PCB 612 of the FPCB assembly 510 rotate with respect to each other, the arrangement of the FPCB assembly 510 may be changed. For example, as the first PCB 611 of the FPCB assembly 510 and the second PCB 612 of the FPCB assembly 510 are rotated according to the change of the distance, a length (e.g., a length in a direction parallel to the first direction or the second direction) of the FPCB assembly 510 may increase or decrease.

For example, when the electronic device 101 is changed from the first state to the second state, as the first PCB 611 of the FPCB assembly 510 and the second PCB 612 of the FPCB assembly 510 are rotated, an angle between the first PCB 611 and the second PCB 612 may increase. When the angle increases, as another end portion (e.g. a second end portion) of the first PCB 611 and another end portion (e.g. a second end portion) of the second PCB 612 move away, the length of the FPCB assembly 510 may increase. For example, when the electronic device 101 is changed from the second state to the first state, as the first PCB 611 and the second PCB 612 are rotated, the angle between the first PCB 611 and the second PCB 612 may decrease. When the angle decreases, as the other end portion of the first PCB 611 and the other end portion of the second PCB 612 become close, the length of the FPCB assembly 510 may decrease.

According to an embodiment, the FPCB assembly 510 may further include a third FPCB 621 and a fourth FPCB 622. The third FPCB 621 of the FPCB assembly 510 may be a portion of the FPCB assembly 510, including a first connector 623 connected to the first PCB 410. An end portion (e.g. a first end portion) of the third FPCB 621 may be rotatably connected to the other end portion (e.g. second end portion) of the first PCB 611 of the FPCB assembly 510. The third FPCB 621 of the FPCB assembly 510 may include the first connector 623 adjacent to the other end (e.g. second end) portion of the third FPCB 621 and connected to the first PCB 410. As the first connector 623 is connected to the first PCB 410, the other end portion (e.g., second end portion) of the third FPCB 621 may be fixed to the first PCB 410.

According to an embodiment, the fourth FPCB 622 of the FPCB assembly 510 may be a portion of the FPCB assembly 510, including a second connector 624 connected to the second PCB 420. An end portion (e.g. first end portion) of the fourth FPCB 622 may be rotatably connected to the other end portion (e.g. second end portion) of the second PCB 612 of the FPCB assembly 510. The fourth FPCB 622 may include the second connector 624 adjacent to the other end portion of the fourth FPCB 622 and connected to the second PCB 420. As the second connector 624 is connected to the second PCB 420, the other end portion of the fourth FPCB 622 may be fixed to the second PCB 420.

According to an embodiment, the FPCB assembly 510 may include one or more link parts 630. For example, the one or more link parts 630 may include at least one link part (e.g., a first link part 631) that rotatably connects the first PCB 611 of the FPCB assembly 510 and the second PCB 612 of the FPCB assembly 510. The first PCB 611 and the second PCB 612 may be rotatably connected to each other through the at least one link part. For example, when the second housing part 220 moves with respect to the first housing part 210, the second PCB 612 may be rotated with respect to the first PCB 611 through the one or more link parts 630.

According to an embodiment, the one or more link parts 630 may include a first link part 631, a second link part 632, and a third link part 633. The first link part 631 may rotatably connect an end portion of the first PCB 611 and an end portion of the second PCB 612 of the FPCB assembly 510. The second link part 632 may rotatably connect another end portion of the first PCB 611 of the FPCB assembly 510 and an end portion of the third FPCB 621. The third link part 633 may rotatably connect another end portion of the second PCB 612 of the FPCB assembly 510 and an end portion of the fourth FPCB 622.

According to an embodiment, the first PCB 611 of the FPCB assembly 510 and the second PCB 612 of the FPCB assembly 510 may be disposed substantially parallel to the first PCB 410 and the second PCB 420. For example, the first PCB 410, the second PCB 420, the first PCB 611 of the FPCB assembly 510, and the second PCB 612 of the FPCB assembly 510 may not be bent and may be disposed on substantially the same plane (e.g., x-y plane). As the first PCB 611 of the FPCB assembly 510 and the second PCB 612 of the FPCB assembly 510, which transmit an electrical signal between the first PCB 410 and the second PCB 420, are disposed in parallel to the first PCB 410 and the second PCB 420, loss of an electrical signal and a change in impedance may be reduced.

According to an embodiment, the first PCB 611 of the FPCB assembly 510 and the second PCB 612 of the FPCB assembly 510 may be relatively more rigid than the third FPCB 621 of the FPCB assembly 510 and the fourth FPCB 622 of the FPCB assembly 510. For example, since the third FPCB 621 is connected and fixed to the first PCB 410 through the first connector 623, it may have relatively high flexibility to be at least partially bent. For example, since the fourth FPCB 622 is connected and fixed to the second PCB 420 through the second connector 624, it may have relatively high flexibility to be at least partially bent when the second housing part 220 is moved with respect to the first housing part 210. Since both end portions of the first PCB 611 may be rotatably connected to the second PCB 612 and the third FPCB 621, and both end portions of the second PCB 612 may be rotatably connected to the first PCB 611 and the fourth FPCB 622, respectively, the first PCB 611 and the second PCB 612 may not be bent. Since the first PCB 611 and the second PCB 612 may not be bent, they may be relatively rigid.

Hereinafter, a detailed structure of the FPCB assembly 510 will be described with reference to the drawings.

FIG. 9A illustrates a flexible printed circuit board (FPCB) assembly when an electronic device is in a first state. FIG. 9B illustrates a flexible printed circuit board (FPCB) assembly when an electronic device is in a second state.

Referring to FIG. 9A, an FPCB assembly 510 may include a plurality of signal lines. The plurality of signal lines may be used as a transmission path for transmitting electrical signals between a first PCB (e.g., the first PCB 410 of FIG. 6) and a second PCB (e.g., the second PCB 420 of FIG. 6). Electrical signals may be transferred between the first PCB 410 and the second PCB 420 through the plurality of signal lines.

According to an embodiment, the first PCB 611 of the FPCB assembly 510 may include a first set of signal lines 910. The second PCB 612 of the FPCB assembly 510 may include a second set of signals 920. Each signal line of the first set of signal lines 910 may be electrically connected to a corresponding signal line of the second set of signal lines 920. For example, the FPCB assembly 510 may be configured to transmit RF signals transmitted to one or more antenna radiators electrically connected to the second PCB 420, from wireless communication circuitry (e.g., the wireless communication module 192 of FIG. 1) on the first PCB 410 through the first set of signal lines 910 and the second set of signal lines 920.

For example, the first set of signal lines 910 may include a first signal line 911, a second signal line 912, and/or a third signal line 913. For example, the second set of signal lines 920 may include a fourth signal line 921, a fifth signal line 922, and/or a sixth signal line 923. The first signal line 911 may be electrically connected to the fourth signal line 921. The second signal line 912 may be electrically connected to the fifth signal line 922. The third signal line 913 may be electrically connected to the sixth signal line 923.

According to an embodiment, the third FPCB 621 may include a third set of signal lines 930. The fourth FPCB 622 may include a fourth set of signal lines 940. The third set of signal lines 930 may be connected to the first connector 623, and each signal line of the third set of signal lines 930 may be electrically connected to a corresponding signal line of the first set of signal lines 910. The fourth set of signal lines 940 may be connected to the second connector 624, and each signal line of the fourth set of signal lines 940 may be electrically connected to a corresponding signal line of the second set of signal lines 920.

For example, the third set of signal lines 930 may include a seventh signal line 931, an eighth signal line 932, and/or a ninth signal line 933. For example, the fourth set of signal lines 940 may include a tenth signal line 941, an eleventh signal line 942, and/or a twelfth signal line 943. The seventh signal line 931 may be electrically connected to the first connector 623 and the first signal line 911. The eighth signal line 932 may be electrically connected to the first connector 623 and the second signal line 912. The ninth signal line 933 may be electrically connected to the first connector 623 and the third signal line 913. The tenth signal line 941 may be electrically connected to the second connector 624 and the fourth signal line 921. The eleventh signal line 942 may be electrically connected to the second connector 624 and the fifth signal line 922. The twelfth signal line 943 may be electrically connected to the second connector 624 and the sixth signal line 923.

According to an embodiment, the FPCB assembly 510 may be configured to electrically connect the first PCB 410 and the second PCB 420 using a plurality of signal lines (e.g. using the first set of signal lines and the second set of signal lines). For example, the wireless communication circuitry 192 disposed on the first PCB 410 may be electrically connected to one or more antenna radiators electrically connected to the second PCB 420, through the FPCB assembly 510. Each of the plurality of signal lines of the FPCB may be configured to transmit RF signals on different frequency bands.

According to an embodiment, the first signal line 911 and the fourth signal line 921 may be configured to transmit a first RF signal on a first frequency band (e.g., low band). The second signal line 912 and the fifth signal line 922 may be configured to transmit a second RF signal on a second frequency band (e.g., midband). The third signal line 913 and the sixth signal line 923 may be configured to transmit a third RF signal on a third frequency band (e.g., high band and/or ultra high band).

For example, the first RF signal transmitted from the wireless communication circuitry 192 to a first antenna radiator (e.g., the first antenna radiator 521 of FIG. 5) may be transmitted from the first PCB 410 to the seventh signal line 931 of the third FPCB 621 through the first connector 623. The first RF signal may be transmitted to the second PCB 420 through the first signal line 911 electrically connected to the seventh signal line 931, the fourth signal line 921 electrically connected to the first signal line 911, the tenth signal line 941 electrically connected to the fourth signal line 921, and the second connector 624. The first RF signal may be transmitted to the first antenna radiator 521 connected to the second PCB 420, and the first antenna radiator 521 may be configured to radiate the first RF signal to the outside of an electronic device (e.g., the electronic device 101 of FIG. 6). A first electrical path for the first RF signal transmitted from the wireless communication circuitry 192 to the first antenna radiator 521 may be formed along the first PCB 410, the first connector 623, the seventh signal line 931 of the third FPCB 621 of the FPCB assembly 510, the first signal line 911 of the first PCB 611 of the FPCB assembly 510, the fourth signal line 921 of the second PCB 612 of the FPCB assembly 510, the tenth signal line 941 of the fourth FPCB 622 of the FPCB assembly 510, the second connector 624, and the second PCB. The first RF signal received from the external electronic device to the first antenna radiator 521 may be transmitted to the wireless communication circuitry 192 along the first electrical path.

For example, a second RF signal on a second frequency band different from the first frequency band may be transmitted along a second electrical path different from the first electrical path for the first RF signal. The second electrical path for the second RF signal transmitted from the wireless communication circuitry 192 to a second antenna radiator (e.g., the second antenna radiator 522 of FIG. 5) may be formed along the first PCB 410, the first connector 623, the eighth signal line 932 of the third FPCB 621 of the FPCB assembly 510, the second signal line 912 of the first PCB 611 of the FPCB assembly 510, the fifth signal line 922 of the second PCB 612 of the FPCB assembly 510, the eleventh signal line 942 of the fourth FPCB 622 of the FPCB assembly 510, the second connector 624, and the second PCB 420. The second antenna radiator 522 may be configured to radiate the second RF signal transmitted from the wireless communication circuitry 192 along the second electrical path to the outside of the electronic device 101. The second RF signal received from the external electronic device to the second antenna radiator 522 may be transmitted to the wireless communication circuitry 192 along the second electrical path.

For example, a third RF signal on a third frequency band different from the first and second frequency bands may be transmitted along a third electrical path different from the first and second electrical paths. The third electrical path for the third RF signal transmitted from the wireless communication circuitry 192 to a third antenna radiator (e.g., the third antenna radiator 523 of FIG. 5) may be formed along the first PCB 410, the first connector 623, the ninth signal line 933 of the third FPCB 621 of the FPCB assembly 510, the third signal line 913 of the first PCB 611 of the FPCB assembly 510, the sixth signal line 923 of the second PCB 612 of the FPCB assembly 510, the twelfth signal line 943 of the fourth FPCB 622 of the FPCB assembly 510, the second connector 624, and the second PCB 420. The third antenna radiator 523 may be configured to radiate the third RF signal transmitted from the wireless communication circuitry 192 along the third electrical path to the outside of the electronic device 101. The third RF signal received from the external electronic device to the third antenna radiator 523 may be transmitted to the wireless communication circuitry 192 along the third electrical path. For example, the signal line 511 of FIG. 5 may correspond to the seventh signal line 931, the first signal line 911, the fourth signal line 921, and the tenth signal line 941. The signal line 512 of FIG. 5 may correspond to the eighth signal line 932, the second signal line 912, the fifth signal line 922, and the eleventh signal line 942. The signal line 513 of FIG. 5 may correspond to the ninth signal line 933, the third signal line 913, the sixth signal line 923, and the twelfth signal line 943.

In the above description, it is described that the FPCB assembly 510 includes three signal lines, but this is only an example for convenience of explanation, and embodiments of the present disclosure are not limited thereto. For example, the FPCB assembly may have more than three signal lines. In examples, the FPCB assembly 510 may include one or more signal lines.

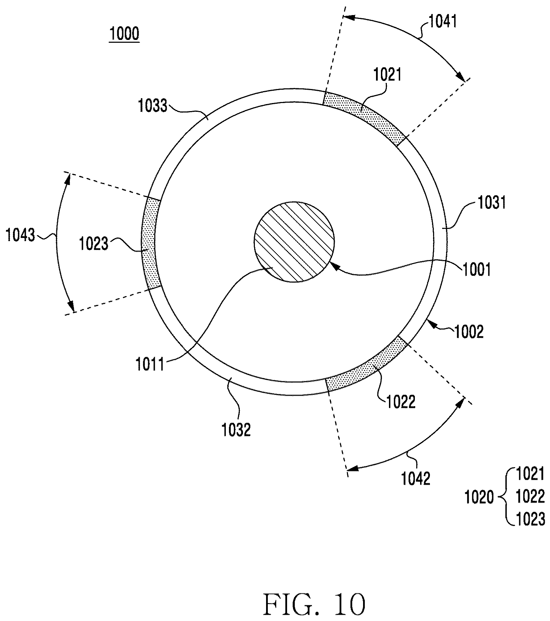

According to an embodiment, one or more link parts 630 may be configured to rotatably connect respective parts of the FPCB assembly 510 and provide an electrical connection between the respective parts. For example, each signal line of the first set of signal lines 910 of the first PCB 611 of the FPCB assembly 510 may be electrically connected to a corresponding signal line of the second set of signal lines 920 through a first link part 631. For example, each signal line of the first set of signal lines 910 of the first PCB 611 may be electrically connected to a corresponding signal line of the third set of signal lines 930 through a second link part 632. For example, each signal line of the second set of signal lines 920 of the second PCB 612 of the FPCB assembly 510 may be electrically connected to a corresponding signal line of the fourth set of signal lines 940 through a third link part 633. A structure in which one or more link parts 630 electrically connect signal lines of the FPCB assembly 510 will be described later with reference to FIGS. 10, 11, 12, 13, 14, 15, 21, and 22.

FIG. 9A illustrates a structure of the FPCB assembly 510 in a first state of the electronic device 101. As described above, in the first state of the electronic device 101, a distance between the first PCB 410 and the second PCB 420 may be relatively close. In the first state of the electronic device 101, the FPCB assembly 510 may have a structure capable of being located within the relatively close distance.

According to an embodiment, the FPCB assembly 510 may have an arrangement structure for reducing a thickness. For example, the first PCB 611 of the FPCB assembly 510 may be connected above (e.g., in +z direction) of the second PCB 612 of the FPCB assembly 510. The second PCB 612 may be connected below the fourth FPCB 622. For example, the first PCB 611 and the fourth FPCB 622 may be disposed on the same plane (e.g., the first plane). The second PCB 612 and the third FPCB 621 may be disposed on the same plane (e.g., the second plane). The first plane may be positioned above the second plane.

Referring to FIG. 9A, in the first state of the electronic device 101, an area where the first PCB 611 of the FPCB assembly 510 and the second PCB 612 of the FPCB assembly 510 overlap each other may be relatively large. In the first state of the electronic device 101, an angle A between the first PCB 611 and the second PCB 612 may be at a minimum. As the first PCB 611 and the second PCB 612 overlap in a relatively large area, a length of the FPCB assembly 510 may be relatively short. As the first PCB 611 and the second PCB 612 are positioned such that the FPCB assembly 510 has a relatively short length, the FPCB assembly 510 may be positioned within the relatively close distance.

The electronic device 101 may be changed from the first state to the second state. For example, as a second housing part (e.g., the second housing part 220 of FIG. 6) moves in the first direction with respect to a first housing part (e.g., the first housing part 210 of FIG. 6), the electronic device 101 may be changed from the first state to the second state. When the second housing part 220 moves in the first direction, the second PCB 420 disposed in the second housing part 220 may move in the first direction together with the second housing part 220. According to the movement, a relative position of the second PCB 420 with respect to the first PCB 410 may move away in the first direction, and a distance between the first PCB 410 and the second PCB 420 may increase.

According to an embodiment, a structure of the FPCB assembly 510 may be changed based on an increase in the distance between the first PCB 410 and the second PCB 420. Since the first connector 623 is connected to the first PCB 410, the third FPCB 621 including the first connector 623 may be fixed. Since the second connector 624 is connected to the second PCB 420, the fourth FPCB 622 including the second connector 624 may be fixed. The first PCB 611 of the FPCB assembly 510 and the second PCB 612 of the FPCB assembly 510 between the fixed third FPCB 621 and the fixed fourth FPCB 622 may be rotated based on the increase in the distance. For example, one or more link parts 630 may be rotated based on the movement, and the first PCB 611 and the second PCB 612 may be rotated by the rotation of link parts.

For example, as the distance increases, the first PCB 611 of the FPCB assembly 510 may be rotated counterclockwise, and the second PCB 612 of the FPCB assembly 510 may be rotated clockwise. The first PCB 611 may be rotated with respect to the second PCB 612 through the first link part 631, and with respect to the third FPCB 621 through the second link part 632. The second PCB 612 may be rotated with respect to the first PCB 611 through the first link part 631, and with respect to the fourth FPCB 622 through the third link part 633. The rotation of the first PCB 611 counterclockwise and the rotation of the second PCB 612 clockwise may widen a gap between the first PCB 611 and the second PCB 612, thereby reducing an area where the first PCB 611 and the second PCB 612 overlap, and increasing an angle A between the first PCB 611 and the second PCB 612. As the second housing part 220 moves by a specified distance in the first direction, a state of the electronic device 101 may be changed from the first state to the second state.

FIG. 9B illustrates a structure of the FPCB assembly 510 in a second state of an electronic device (e.g., the electronic device 101 of FIG. 8). As described above, in the second state of the electronic device 101, a distance between a first PCB (e.g., the first PCB 410 of FIG. 8) and a second PCB (e.g., the second PCB 420 of FIG. 8) may be relatively far. In the second state of the electronic device 101, the FPCB assembly 510 may have a structure capable of being located within a relatively far distance.

Referring to FIG. 9B, in the second state of the electronic device 101, an area where the first PCB 611 of the FPCB assembly 510 and the second PCB 612 of the FPCB assembly 510 overlap each other may be relatively small. In the first state of the electronic device 101, an angle A between the first PCB 611 and the second PCB 612 may be at a maximum. As the first PCB 611 and the second PCB 612 overlap in a relatively narrow area, a length of the FPCB assembly 510 may be relatively long. As the first PCB 611 and the second PCB 612 are positioned such that the FPCB assembly 510 has a relatively long length, the FPCB assembly 510 may be positioned within the relatively long distance. As the distance increases, the first PCB 611 and the second PCB 612 are rotated so that the FPCB assembly 510 maintains a state of being connected to the first PCB 410 and the second PCB 420.

When the state of the electronic device 101 is changed from the second state to the first state, the first PCB 611 of the FPCB assembly 510 and the second PCB 612 of the FPCB assembly 510 may be rotated in a rotation direction opposite to the rotation direction described above.

For example, as the second housing part 220 moves in the second direction with respect to the first housing part 210, the distance between the first PCB 410 and the second PCB 420 may decrease. As the distance decreases, the first PCB 611 of the FPCB assembly 510 may be rotated clockwise, and the second PCB 612 of the FPCB assembly 510 may be rotated counterclockwise. The rotation of the first PCB 611 clockwise and the rotation of the second PCB 612 counterclockwise may narrow a gap between the first PCB 611 and the second PCB 612, thereby increasing the area where the first PCB 611 and the second PCB 612 overlap and reducing the angle A between the first PCB 611 and the second PCB 612.

According to an embodiment, even when the structure of the FPCB assembly 510 is changed, the first PCB 611 of the FPCB assembly 510 and the second PCB 612 of the FPCB assembly 510 may be maintained in a flat state without bending. Since the first PCB 611 and the second PCB 612 are rotated through one or more link parts 630 according to a change in the distance between the first PCB 410 and the second PCB 420, they may be relatively rigid without having relatively high flexibility to avoid bending. Since the first PCB 611 and the second PCB 612 are rigid, loss of electrical signals and impedance changes transmitted through the FPCB assembly 510 may be reduced.

According to an embodiment, the first PCB 611 (e.g. first assembly PCB) of the FPCB assembly 510 and the second PCB 612 (e.g. second assembly PCB) of the FPCB assembly 510 rotate on substantially the same plane as a plane on which the first PCB 410 and the second PCB 420 are disposed, and thus may be disposed in parallel with the first PCB 410 and the second PCB 420. When the first PCB 611 and the second PCB 612 are disposed perpendicular to the first PCB 410 and the second PCB 420, a thickness of a space for accommodating the FPCB assembly 510 may be increased. As the first PCB 611 and the second PCB 612 of the FPCB assembly 510 are disposed in parallel with the first PCB 410 and the second PCB 420 disposed within the first and second housing, respectively, a thickness of the electronic device 101 may be reduced.

According to an embodiment, one or more link parts 630 may be configured to provide an electrical connection between each part of the FPCB assembly 510. Hereinafter, a structure of the one or more link parts 630 will be described.

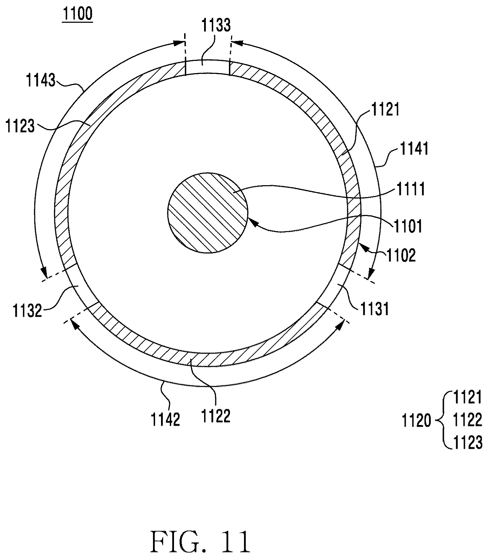

FIG. 10 illustrates a first sub link part. FIG. 11 illustrates a second sub link part.

Referring to FIGS. 10 and 11, each of one or more link parts (e.g., the one or more link parts 630 of FIG. 6) may include a first sub link part (e.g., the first sub link part 1000 of FIG. 10) and a second sub link part (e.g., the second sub link part 1100 of FIG. 11). For example, a first link part (e.g., the first link part 631 of FIG. 6), a second link part (e.g., the second link part 632 of FIG. 6), and a third link part (e.g., the third link part 633 of FIG. 6) may include (e.g. may each include) the first sub link part 1000 and the second sub link part 1100, respectively. The first sub link part 1000 and the second sub link part 1100 may be rotatably coupled to each other. For example, when a second housing part (e.g., the second housing part 220 of FIG. 6) moves with respect to a first housing part (e.g., the first housing part 210 of FIG. 6), the first sub link part 1000 and the second sub link part 1100 may be rotated with respect to each other.

For example, the first sub link part 1000 of the first link part 631 may be connected to a first PCB (e.g., the first PCB 611 of FIG. 6) of an FPCB assembly (e.g., the FPCB assembly 510 of FIG. 6), and the second sub link part 1100 of the second link part 632 may be connected to a second PCB (e.g., the second PCB 612 of FIG. 6) of the FPCB assembly 510. For example, the first sub link part 1000 of the second link part 632 may be connected to the first PCB 611, and the second sub link part 1100 of the second link part 632 may be connected to a third FPCB (e.g., the third FPCB 621 of FIG. 6). For example, the first sub link part 1000 of the third link part 633 may be connected to the second PCB 612, and the second sub link part 1100 of the third link part 633 may be connected to a fourth FPCB (e.g., the fourth FPCB 622 of FIG. 6).

Referring to FIG. 10, the first sub link part 1000 may include a first set of conductive patterns 1020. Referring to FIG. 11, the second sub link part 1100 may include a second set of conductive patterns 1120. When the first sub link part 1000 and the second sub link part 1100 are coupled with each other, the first set of conductive patterns 1020 may be contacted to the second set of conductive patterns 1120, respectively. Through the contact, each conductive pattern of the second set of conductive patterns 1120 may be electrically connected to a corresponding conductive pattern of the first set of conductive patterns 1020. According to an embodiment, each conductive pattern of the first set of conductive patterns 1020 and each conductive pattern of the second set of conductive patterns 1120 may be configured to be electrically connected to each other. Even when at least one of the first sub link part 1000 and the second sub link part 1100 is rotated, an electrical connection between each conductive pattern of the first set of conductive patterns 1020 and each conductive pattern of the second set of conductive patterns 1120 may be configured to be maintained.

For example, the first set of conductive patterns 1020 may include a first conductive pattern 1021, a second conductive pattern 1022, and/or a third conductive pattern 1023. The second set of conductive patterns 1120 may include a fourth conductive pattern 1121, a fifth conductive pattern 1122, and/or a sixth conductive pattern 1123. When the first sub link part 1000 and the second sub link part 1100 are coupled to each other, as the first conductive pattern 1021 and the fourth conductive pattern 1121 may be contacted with each other, the first conductive pattern 1021 and the fourth conductive pattern 1121 may be electrically connected to each other. When the first sub link part 1000 and the second sub link part 1100 are coupled to each other, as the second conductive pattern 1022 and the fifth conductive pattern 1122 are contacted with each other, the second conductive pattern 1022 and the fifth conductive pattern 1122 may be electrically connected to each other. When the first sub link part 1000 and the second sub link part 1100 are coupled to each other, as the third conductive pattern 1023 and the sixth conductive pattern 1123 are contacted with each other, the third conductive pattern 1023 and the sixth conductive pattern 1123 may be electrically connected to each other. The numbers of the first set of conductive patterns 1020 and the second set of conductive patterns 1120 described above are only examples, and embodiments of the present disclosure are not limited thereto. For example, the first sub link part 1000 and the second sub link part 1100 may include one or more conductive patterns.

According to an embodiment, the first set of conductive patterns 1020 of the first sub link part 1000 and the second set of conductive patterns 1120 of the second sub link part 1100 may be configured to electrically connect signal lines of each part of the FPCB assembly 510.

According to an embodiment, in a case of the first sub link part 1000 and the second sub link part 1100 included in the first link part 631 electrically connecting the first PCB 611 and the second PCB 612, the first set of conductive patterns 1020 may be electrically connected to a first set of signal lines (e.g., the first set of signal lines 910 of FIG. 9A) of the first PCB 611, respectively, and the second set of conductive patterns 1120 may be electrically connected to a second set of signal lines (e.g., the second set of signal lines 920 of FIG. 9A) of the second PCB 612, respectively. In this case, the first set of signal lines 910 of the first PCB 611 and the second set of signal lines 920 of the second PCB 612 may be electrically connected through the first set of conductive patterns 1020 and the second set of conductive patterns 1120.

For example, in the case, the first conductive pattern 1021 of the first sub link part 1000 may be electrically connected to a first signal line (e.g., the first signal line 911 of FIG. 9A) of the first PCB 611. The fourth conductive pattern 1121 of the second sub link part 1100 may be electrically connected to a fourth signal line (e.g., the fourth signal line 921 of FIG. 9A) of the second PCB 612. When the second sub link part 1100 is coupled to the first sub link part 1000, since the fourth conductive pattern 1121 is electrically connected to the first conductive pattern 1021, the first signal line 911 and the fourth signal line 921 may be electrically connected.

For example, in the case, the second conductive pattern 1022 of the first sub link part 1000 may be electrically connected to a second signal line (e.g., the second signal line 912 of FIG. 9A) of the first PCB 611. The fifth conductive pattern 1122 of the second sub link part 1100 may be electrically connected to a fifth signal line (e.g., the fifth signal line 922 of FIG. 9A) of the second PCB 612. When the second sub link part 1100 is coupled to the first sub link part 1000, since the fifth conductive pattern 1122 is electrically connected to the second conductive pattern 1022, the second signal line 912 and the fifth signal line 922 may be electrically connected.

For example, in the case, the third conductive pattern 1023 of the first sub link part 1000 may be electrically connected to a third signal line (e.g., the third signal line 913 of FIG. 9A) of the first PCB 611. The sixth conductive pattern 1123 of the second sub link part 1100 may be electrically connected to a sixth signal line (e.g., the sixth signal line 923 of FIG. 9A) of the second PCB 612. When the second sub link part 1100 is coupled to the first sub link part 1000, since the sixth conductive pattern 1123 is electrically connected to the third conductive pattern 1023, the third signal line 913 and the sixth signal line 923 may be electrically connected.

According to an embodiment, in a case of the first sub link part 1000 and the second sub link part 1100 included in the second link part 632, the first set of conductive patterns 1020 may be electrically connected to the first set of signal lines 910 of the first PCB 611, respectively, and the second set of conductive patterns 1120 may be electrically connected to a third set of signal lines (e.g., the third set of signal lines 930 of FIG. 9A) of the third FPCB 621, respectively. In this case, the first set of signal lines 910 of the first PCB 611 and the third set of signal lines 930 of the third FPCB 621 may be electrically connected through the first set of conductive patterns 1020 and the second set of conductive patterns 1120 of the second link part 632.

According to an embodiment, in a case of the first sub link part 1000 and the second sub link part 1100 included in the third link part 633, the first set of conductive patterns 1020 may be electrically connected to the second set of signal lines 920 of the second PCB 612, respectively, and the second set of conductive patterns 1120 may be electrically connected to a fourth set of signal lines (e.g., the fourth set of signal lines 940 of FIG. 9A) of the fourth FPCB 622, respectively. In this case, the second set of signal lines 920 of the second PCB 612 and the fourth set of signal lines 940 of the fourth FPCB 622 may be electrically connected through the first set of conductive patterns 1020 and the second set of conductive patterns 1120 of the third link part 633.

According to an embodiment, the first sub link part 1000 and the second sub link part 1100 may be configured to transmit an electrical signal between parts of the FPCBs. For example, a first RF signal transmitted between the first PCB 611 and the second PCB 612 may be transmitted from the first signal line 911 to the fourth signal line 921, through the first conductive pattern 1021 of the first sub link part 1000 and the fourth conductive pattern 1121 of the second sub link part 1100. For example, a second RF signal transmitted between the first PCB 611 and the second PCB 612 may be transmitted from the second signal line 912 to the fifth signal line 922 through the second conductive pattern 1022 of the first sub link part 1000 and the fifth conductive pattern 1122 of the second sub link part 1100. For example, the third RF signal transmitted between the first PCB 611 and the second PCB 612 may be transmitted from the third signal line 913 to the sixth signal line 923 through the third conductive pattern 1023 of the first sub link part 1000 and the sixth conductive pattern 1123 of the second sub link part 1100.

The above descriptions may be substantially identically applied to the second link part 632 and the third link part 633. For example, through the first sub link part 1000 and the second sub link part 1100 of the second link part 632, the first set of signal lines 910 of the first PCB 611 and the third set of signal lines 930 of the third FPCB 621 may be electrically connected, respectively. For example, through the first sub link part 1000 and the second sub link part 1100 of the third link part 633, the second set of signal lines 920 of the second PCB 612 and the fourth set of signal lines 940 of the fourth FPCB 622 may be electrically connected, respectively.

According to an embodiment, the first sub link part 1000 and the second sub link part 1100 may have a circular cross-section.

Referring to FIG. 10, the first sub link part 1000 may include a first core portion 1001 and a first peripheral portion 1002 surrounding the first core portion 1001. In examples, the first core portion 1001 may be formed at a center (central) portion of the first sub link part 1000. The first peripheral portion 1002 may be formed to comprise an area around an edge, or circumference (e.g. when the sub link part 1000 is circular), of the first sub link part 1000. In examples, the first peripheral portion 1002 may be spaced apart from the first core portion 1001. The first core portion 1001 may be electrically connected to a ground of the electronic device 101. The first core portion 1001 may be a first ground portion 1011 of the first sub link part 1000. For example, the first core portion 1001 may be connected to a ground layer of the first PCB 611 electrically connected to the ground of the electronic device 101. The first set of conductive patterns 1020 may be disposed in the first peripheral portion 1002. For example, a portion of the first peripheral portion 1002 may be defined by the first set of conductive patterns 1020. As the first set of conductive patterns 1020 for transmitting RF signals is disposed to surround the first ground portion 1011 electrically connected to the ground, noise may be reduced and stability of signal transmission may be improved.

According to an embodiment, the first conductive pattern 1021, the second conductive pattern 1022, and the third conductive pattern 1023 may define a portion of the first peripheral portion 1002. For example, the first conductive pattern 1021 may define a first region 1041 of the first peripheral portion 1002. The second conductive pattern 1022 may define a second region 1042 of the first peripheral portion 1002. The third conductive pattern 1023 may define a third region 1043 of the first peripheral portion 1002. Referring to FIG. 10, a circumference of the first region 1041 defined by the first conductive pattern 1021 may be referred to as a first circumference . A circumference of the second region 1042 defined by the second conductive pattern 1022 may be referred to as a second circumference. A circumference of the third region 1043 defined by the third conductive pattern 1023 may be referred to as a third circumference. The first circumference, the second circumference, and the third circumference may be substantially the same, but are not limited thereto. For example, the first circumference, the second circumference and the third circumference may refer to a length of a circumferential portion, or an arc portion, of the respective regions of the peripheral portion (e.g. first peripheral portion 1002, which is formed as an area around an edge or circumference of the sub link part). That is, each of the regions (corresponding to the conductive patterns) may therefore have a corresponding length, where the length of the region is a portion, or part, of the circumference of the peripheral portion 1002.

According to an embodiment, the first set of conductive patterns 1020 may be spaced apart from each other. For example, in the first peripheral portion 1002, a plurality of non-conductive patterns for spacing the first conductive pattern 1021, the second conductive pattern 1022, and the third conductive pattern 1023 apart from each other may be disposed. For example, a first non-conductive pattern 1031 may be disposed between the first conductive pattern 1021 and the second conductive pattern 1022. The first conductive pattern 1021 and the second conductive pattern 1022 may be physically and electrically separated by the first non-conductive pattern 1031. A second non-conductive pattern 1032 may be disposed between the second conductive pattern 1022 and the third conductive pattern 1023. The second conductive pattern 1022 and the third conductive pattern 1023 may be physically and electrically separated by the second non-conductive pattern 1032. A third non-conductive pattern 1033 may be disposed between the first conductive pattern 1021 and the third conductive pattern 1023. The first conductive pattern 1021 and the third conductive pattern 1023 may be physically and electrically separated by the third non-conductive pattern 1033.

As described above, RF signals may be transmitted between the first PCB 611 of the FPCB assembly 510 and the second PCB 612 of the FPCB assembly 510 through the plurality of conductive patterns. Since the first set of conductive patterns 1020 is physically and electrically separated by the plurality of non-conductive patterns, interference between RF signals transmitted through the first set of conductive patterns 1020 may be reduced. For example, as a first RF signal transmitted through the first conductive pattern 1021, a second RF signal transmitted through the second conductive pattern 1022, and a third RF signal transmitted through the third conductive pattern 1023 are transmitted through the first conductive pattern 1021, the second conductive pattern 1022, and the third conductive pattern 1023, which are physically and electrically separated, respectively, interference between RF signals may be reduced.

The descriptions of the structure of the first sub link part 1000 illustrated in FIG. 10 may be substantially identically applied to the structure of the second sub link part 1100 illustrated in FIG. 11.

Referring to FIG. 11, the second sub link part 1100 may include a second core portion 1101 and a second peripheral portion 1102 surrounding the second core portion 1101. The second core portion 1101 may be electrically connected to a ground of the electronic device 101. The second core portion 1101 may be a second ground portion 1111 of the second sub link part 1100. When the second sub link part 1100 is coupled to a first sub link part (e.g., the first sub link part 1000 of FIG. 10), the second core portion 1101 may be contacted with the first core portion 1001. A second set of conductive patterns 1120 may be disposed in the second peripheral portion 1102. For example, a portion of the second peripheral portion 1102 may be defined by the second set of conductive patterns 1120. As the second set of conductive patterns 1120 for transmitting RF signals is disposed to surround the second ground portion 1111 electrically connected to the ground, noise may be reduced and stability of signal transmission may be improved.

According to an embodiment, a fourth conductive pattern 1121, a fifth conductive pattern 1122, and a sixth conductive pattern 1123 may define a portion of the second peripheral portion 1102. For example, the fourth conductive pattern 1121 may define a fourth region 1141 of the second peripheral portion 1102. The fifth conductive pattern 1122 may define a fifth region 1142 of the second peripheral portion 1102. The sixth conductive pattern 1123 may define a sixth region 1143 of the second peripheral portion 1102. Referring to FIG. 10, a circumference of the fourth region 1141 defined by the fourth conductive pattern 1121 may be referred to as a fourth circumference. A circumference of the fifth region 1142 defined by the fifth conductive pattern 1122 may be referred to as a fifth circumference. A circumference of the sixth region 1143 defined by the sixth conductive pattern 1123 may be referred to as a sixth circumference. The fourth circumference, the fifth circumference, and the sixth circumference may be substantially the same, but are not limited thereto. For example, when the second sub link part 1100 is coupled to the first sub link part 1000, the fourth region 1141 may be contacted with the first region 1041. When the second sub link part 1100 is coupled to the first sub link part 1000, the fifth region 1142 may be contacted with the second region 1042. When the second sub link part 1100 is coupled to the first sub link part 1000, the sixth region 1143 may be contacted with the third region 1043.

According to an embodiment, the second set of conductive patterns 1120 may be spaced apart from each other. For example, in the second peripheral portion 1102, a plurality of non-conductive patterns for spacing the fourth conductive pattern 1121, the fifth conductive pattern 1122, and the sixth conductive pattern 1123 apart from each other may be disposed. For example, a fourth non-conductive pattern 1131 may be disposed between the fourth conductive pattern 1121 and the fifth conductive pattern 1122. The fourth conductive pattern 1121 and the fifth conductive pattern 1122 may be physically and electrically separated by the fourth non-conductive pattern 1131. A fifth non-conductive pattern 1132 may be disposed between the fifth conductive pattern 1122 and the sixth conductive pattern 1123. The fifth conductive pattern 1122 and the sixth conductive pattern 1123 may be physically and electrically separated by the fifth non-conductive pattern 1132. A sixth non-conductive pattern 1133 may be disposed between the fourth conductive pattern 1121 and the sixth conductive pattern 1123. The fourth conductive pattern 1121 and the sixth conductive pattern 1123 may be physically and electrically separated by the sixth non-conductive pattern 1133.

As described above, RF signals may be transmitted between the first PCB 611 of the FPCB assembly 510 and the second PCB 612 of the FPCB assembly 510 through the plurality of conductive patterns. As the second set of conductive patterns 1120 is physically and electrically separated by the plurality of non-conductive patterns, interference between RF signals transmitted through the second set of conductive patterns 1120 may be reduced. For example, a first RF signal transmitted through the fourth conductive pattern 1121, a second RF signal transmitted through the fifth conductive pattern 1122, and a third RF signal transmitted through the sixth conductive pattern 1123 are transmitted through the fourth conductive pattern 1121, the fifth conductive pattern 1122, and the sixth conductive pattern 1123, which are physically and electrically separated respectively, interference between RF signals may be reduced.

As described above, the first sub link part 1000 and the second sub link part 1100 may be rotated based on movement of the first housing part 210 or movement of the second housing part 220. For example, when the second housing part 220 moves with respect to the first housing part 210, the first sub link part 1000 (or the second sub link part 1100) may be rotated with respect to the second sub link part 1100 (or the first sub link part 1000). Even when the first sub link part 1000 and/or the second sub link part 1100 rotate for transmitting signals, a contact between the first set of conductive patterns 1020 and the second set of conductive patterns 1120 should be maintained so that an electrical connection for transmitting RF signal lines may be maintained. In order to maintain the contact, a circumference of each conductive pattern of the second set of conductive patterns 1120 may be longer than a circumference of a corresponding conductive pattern of the first set of conductive patterns 1020.

For example, a length of each conductive pattern of each of the second set of conductive patterns (e.g. a length of each arc portion, or circumferential portion, or edge, that forms each conductive pattern), may be longer than the length of each respective conductive pattern of the first set of conductive patterns to which it is electrically connected. That is, a contact (e.g. to provide the electrical connection) may be maintained, as when a movement of the first or second housing part causes rotation of the first or second sub link part (that is, the first sub link part or second sub link part rotate in accordance with the movement), the shorter conductive patterns of the first set of conductive patterns 1020 maintain contact with the longer conductive patterns of the second set of conductive patterns 1120. For example, when the second link part 1100 and the first sub link part 1100 are coupled (e.g. aligning, or overlapping, the first and second link parts), the length of the second set of conductive patterns 1120 may be aligned with, and longer, than the first set of conductive patterns in a rotational direction, such that when the first sub link part 1000 is rotated respective to the second sub link part 1100 (e.g. in a clockwise direction), the contact between the first and second set of conductive patterns is maintained.

Hereinafter, a structure in which the contact is maintained when the first sub link part 1000 or the second sub link part 1100 rotates is described.

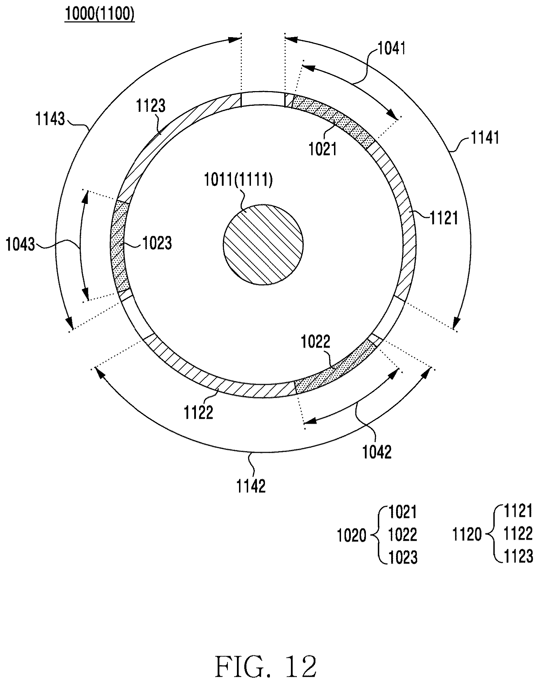

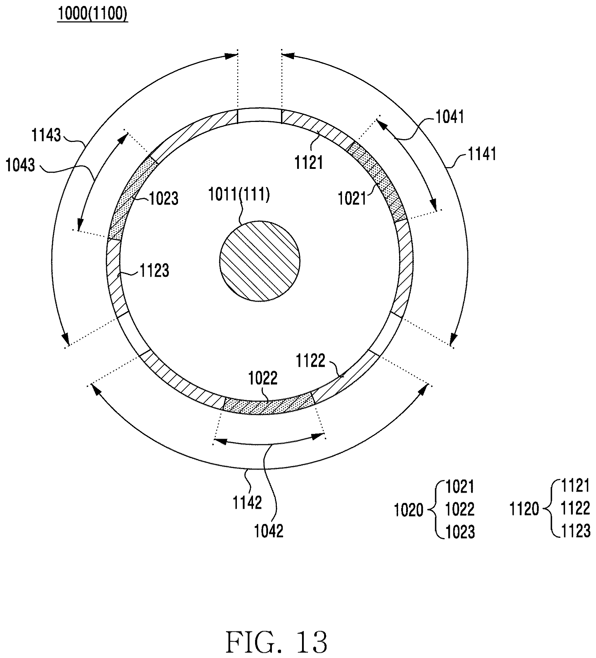

FIG. 12 illustrates a first sub link part and a second sub link part coupled with each other in a first state of an electronic device. FIG. 13 illustrates a first sub link part and a second sub link part coupled with each other in a second state of an electronic device.

Referring to FIG. 12, a first sub link part 1000 and a second sub link part 1100 may be coupled to each other. When the second sub link part 1100 is coupled to the first sub link part 1000, a second ground portion 1111 may be contacted with the first ground portion 1011. As the first ground portion 1011 and the second ground portion 1111 are in contact with each other, the first ground portion 1011 and the second ground portion 1111 may be electrically connected. When the second sub link part 1100 is coupled to the first sub link part 1000, each conductive pattern of the second set of conductive patterns 1120 may be in contact with a corresponding conductive pattern of the first set of conductive patterns 1020. For example, a fourth conductive pattern 1121 may be contacted with a first conductive pattern 1021. A fifth conductive pattern 1122 may be contacted with a second conductive pattern 1022. A sixth conductive pattern 1123 may be contacted with a third conductive pattern 1023.

According to an embodiment, a circumference of each conductive pattern of the second set of conductive patterns 1120 may be longer than a circumference of a corresponding conductive pattern of the first set of conductive patterns 1020.

For example, a fourth circumference of a fourth region 1141 defined by the fourth conductive pattern 1121 may be longer than a first circumference of a first region 1041 defined by the first conductive pattern 1021 corresponding to the fourth conductive pattern 1121. A fifth circumference of a fifth region 1142 defined by the fifth conductive pattern 1122 may be longer than a second circumference of a second region 1042 defined by the second conductive pattern 1022 corresponding to the fifth conductive pattern 1122. A sixth circumference of a sixth region 1143 defined by the sixth conductive pattern 1123 may be longer than a third circumference of a third region 1043 defined by the third conductive pattern 1023 corresponding to the sixth conductive pattern 1123.

FIG. 12 illustrates a first sub link part 1000 and a second sub link part 1100 within a first state of an electronic device (e.g., the electronic device 101 of FIG. 6). While a state of the electronic device 101 is changed from a first state to a second state, the first sub link part 1000 or the second sub link part 1100 may be rotated. Hereinafter, for convenience of explanation, it is described that the first sub link part 1000 is rotated with respect to the second sub link part 1100, but embodiments of the present disclosure are not limited thereto. For example, a rotation of the first sub link part 1000 with respect to the second sub link part 1100 may be referenced as a change in a relative arrangement relationship between the first sub link part 1000 and the second sub link part 1100 as the first sub link part 1000 and the second sub link part 1100 are rotated with respect to each other.

While the state of the electronic device 101 is changed from the first state to the second state, the first sub link part 1000 may be rotated with respect to the second sub link part 1100. For example, the first sub link part 1000 may be rotated clockwise with respect to the second sub link part 1100. When the state of the electronic device 101 becomes the second state, the first sub link part 1000 and the second sub link part 1100 may be changed from the arrangement illustrated in FIG. 12 to the arrangement illustrated in FIG. 13.

Referring to FIG. 13, as the first sub link part 1000 is rotated, a relative position of the first set of conductive patterns 1020 may be changed. Even when the relative position of the first set of conductive patterns 1020 is changed, due to a difference in the circumferences described above, each conductive pattern of the second set of conductive patterns 1120 may be contacted with a corresponding conductive pattern of the first set of conductive patterns 1020. When the first sub link part 1000 or the second sub link part 1100 is rotated according to movement of the first housing part 210 or the second housing part 220, since each conductive pattern of the second set of conductive patterns 1120 maintains contact with the corresponding conductive pattern of the first set of conductive patterns 1020, each conductive pattern of the second set of conductive patterns 1120 may be configured to be electrically connected to the corresponding conductive pattern of the first set of conductive patterns 1020, respectively.

For example, as the first sub link part 1000 is rotated clockwise, the first conductive pattern 1021 may move clockwise within a certain rotation range. Even when the first conductive pattern 1021 moves clockwise, since the fourth circumference of the fourth region 1141 is longer than the first circumference of the first region 1041, the fourth conductive pattern 1121 may be contacted with the first conductive pattern 1021. Even when the state of the electronic device 101 is changed, as the contact between the first conductive pattern 1021 and the fourth conductive pattern 1121 is maintained, the first conductive pattern 1021 and the fourth conductive pattern 1121 may be electrically connected.

For example, as the first sub link part 1000 is rotated clockwise, the second conductive pattern 1022 may move clockwise within a certain rotation range. Even when the second conductive pattern 1022 moves clockwise, since the fifth circumference of the fifth region 1142 is longer than the second circumference of the second region 1042, the fifth conductive pattern 1122 may be contacted with the second conductive pattern 1022. Even when the state of the electronic device 101 is changed, as the contact between the second conductive pattern 1022 and the fifth conductive pattern 1122 is maintained, the second conductive pattern 1022 and the fifth conductive pattern 1122 may be electrically connected.

For example, as the first sub link part 1000 is rotated clockwise, the third conductive pattern 1023 may move clockwise within a certain rotation range. Even when the third conductive pattern 1023 moves clockwise, since the sixth circumference of the sixth region 1143 is longer than the third circumference of the third region 1043, the sixth conductive pattern 1123 may be contacted with the third conductive pattern 1023. Even when the state of the electronic device 101 is changed, as the contact between the third conductive pattern 1023 and the sixth conductive pattern 1123 is maintained, the third conductive pattern 1023 and the sixth conductive pattern 1123 may be electrically connected.

The above description has been described based on a change from the first state of the electronic device 101 to the second state of the electronic device 101, but the above description may be substantially identically applied in the opposite case. While the state of the electronic device 101 is changed from the second state to the first state, the first sub link part 1000 may be rotated counterclockwise with respect to the second sub link part 1100. Even when the first sub link part 1000 is rotated counterclockwise with respect to the second sub link part 1100, as each conductive pattern of the second set of conductive patterns 1120 maintains contact with the corresponding conductive pattern of the first set of conductive patterns 1020, each conductive pattern of the second set of conductive patterns 1120 may be configured to be electrically connected to the corresponding conductive pattern of the first set of conductive patterns 1020, respectively.

According to an embodiment, a first PCB (e.g., the first PCB 611 of FIG. 6) of an FPCB assembly (e.g., the FPCB assembly 510 of FIG. 5) and a second PCB (e.g., the second PCB 612 of FIG. 6) of the FPCB assembly 510 may be configured to rotate with respect to each other, through a rotation of the first sub link part 1000 or the second sub link part 1100 of a first link part (e.g., the first link part 631 of FIG. 6). Even when the first PCB 611 or the second PCB 612 is rotated, as the contact between the first set of conductive patterns 1020 and the second set of conductive patterns 1120 for RF signals may be maintained, an electrical connection between a first PCB (e.g., the first PCB 410 of FIG. 6) and a second PCB (e.g., the second PCB 420 of FIG. 6) may be stably maintained. The above description may be substantially identically applied to a second link part (e.g., the second link part 632 of FIG. 6) and a third link part (e.g., the third link part 633 of FIG. 6).

According to an embodiment, independently of the state of the electronic device 101, each conductive pattern of the first set of conductive patterns 1020 may only be contacted with a corresponding conductive pattern of the second set of conductive patterns 1120. For example, each conductive pattern of the first set of conductive patterns 1020 may not be contacted with another conductive pattern different from the corresponding conductive pattern of the second set of conductive patterns 1120. Even when the state of the electronic device 101 is changed, the first set of conductive patterns 1020 and the second set of conductive patterns 1120 may maintain a designated one-to-one correspondence. Since the first set of conductive patterns 1020 and the second set of conductive patterns 1120 maintain a designated one-to-one correspondence, transmission of RF signals may be stably provided.

For example, as illustrated in FIGS. 12 and 13, the first conductive pattern 1021 may be contacted with the fourth conductive pattern 1121 of the second set of conductive patterns 1120. The first conductive pattern 1021 may not be contacted with the fifth conductive pattern 1122 or the sixth conductive pattern 1123 that is different from the fourth conductive pattern 1121. The second conductive pattern 1022 may be contacted with the fifth conductive pattern 1122 of the second set of conductive patterns 1120. The second conductive pattern 1022 may not be contacted with the fourth conductive pattern 1121 or the sixth conductive pattern 1123 that is different from the fifth conductive pattern 1122. The third conductive pattern 1023 may be contacted with the sixth conductive pattern 1123 of the second set of conductive patterns 1120. The third conductive pattern 1023 may not be contacted with the fourth conductive pattern 1121 or the fifth conductive pattern 1122 that is different from the sixth conductive pattern 1123.

If, when the first sub link part 1000 is rotated according to a change in the state of the electronic device 101, the first conductive pattern 1021 is contacted with the fifth conductive pattern 1122 or the sixth conductive pattern 1123 that is different from the fourth conductive pattern 1121, which is a corresponding conductive pattern, the first RF signal may interfere with the second RF signal or the third RF signal. According to an embodiment, even when the first sub link part 1000 or the second sub link part 1100 is rotated, as the first set of conductive patterns 1020 and the second set of conductive patterns 1120 maintain a designated one-to-one correspondence, transmission of RF signals may be stably provided.

The first sub link part 1000 and the second sub link part 1100 described with reference to FIGS. 10, 11, 12, and 13 have been described as including conductive patterns for three signal lines, respectively, but the embodiments of the present disclosure are not limited thereto. For example, the number of signal lines may be determined according to the number of one or more antenna radiators, and the number of conductive patterns may be determined according to the number of signal lines.

An example of the design of the first sub link part 1000 and the second sub link part 1100 is described. The first sub link part 1000 and the second sub link part 1100 described below are only an example to help understanding, and the embodiments of the present disclosure are not limited to a structure described below.

For example, the first sub link part 1000 may be referenced as a male type, and the second sub link part 1100 may be referenced as a female type. A circumference of the second set of conductive patterns 1120 included in the second sub link part 1100 of the female type may be set longer than a circumference of the first set of conductive patterns 1020 included in the first sub link part 1000 of the male type. For example, a circumference of each conductive pattern of the first set of conductive patterns 1020 may be set to about 10% of a circumference of a corresponding conductive pattern of the second set of conductive patterns 1120. A circumference ratio assigned to each conductive pattern of the second set of conductive patterns 1120 may be determined according to the number of signals. As described above, when there are three signal lines, 120 degrees (360 degrees / 3) may be assigned to each conductive pattern of the second set of conductive patterns 1120. Herein, if a design margin according to the rotation of the first sub link part 1000 is determined to be about 10%, about 108 degrees may be assigned to each conductive pattern of the second set of conductive patterns 1120, respectively. When the state of the electronic device 101 is changed, if the first link part 631 is rotated by about 60 degrees, each conductive pattern of the first set of conductive patterns 1020 should be rotated within a range contacting with a corresponding conductive pattern of the second set of conductive patterns 1120, so about 48 degrees (e.g., 108 degrees - 60 degrees) may be assigned to each conductive pattern of the second set of conductive patterns 1120, respectively. If a minimum separation distance between conductive patterns is determined to be about 0.9 mm to satisfy an isolation characteristic based on a specified frequency band (e.g., 3.5 GHz), a length excluding about 0.9 mm from a circumference corresponding to 48 degrees with respect to the entire circumference may be referred to as a circumference assigned to each conductive pattern of the second set of conductive patterns 1120.

For example, when the circumference of the first link part 631 is about 18 mm and there are 3 signal lines, 6 mm, which is obtained by dividing about 18 mm by the number of signal lines, is assigned to each conductive pattern of the second set of conductive patterns 1120. Herein, excluding a margin of about 10% due to a rotational operation of the first link part 631, 5.4 mm remains, and excluding 3 mm corresponding to about 60 degrees so that the first link part 631 may be rotated by about 60 degrees, 2.4 mm remains. Herein, when excluding about 0.9 mm corresponding to about 18 degrees to satisfy an isolation characteristic, 1.5 mm (e.g., 2.4 mm - 0.9 mm) is assigned to each conductive pattern of the second set of conductive patterns 1120. When the circumference of each conductive pattern of the first set of conductive patterns 1020 is set to about 25% of the circumference of the corresponding conductive pattern of the second set of conductive patterns 1120 (e.g., including a separation distance for satisfying the isolation characteristic and a margin length due to rotational operation), 1.5 mm is assigned to each conductive pattern of the second set of conductive patterns 1120. When a ratio of the circumference of the corresponding conductive pattern of the first set of conductive patterns 1020 with respect to the circumference of each conductive pattern of the second set of conductive patterns 1120 is less than about 25%, a range of rotational operation may be greater than about 60 degrees. The range of the rotational operation may affect a moving distance of a second housing part (e.g., the second housing part 220 of FIG. 6) with respect to a first housing part (e.g., the first housing part 210 of FIG. 6).

As described above, a circumference (or length) of each conductive pattern of the second set of conductive patterns 1120 may be longer than a circumference (or length) of each respective conductive pattern of the first set of conductive patterns (1020) to which it is electrically connected. Due to this difference in circumference (or length), when the first sub link part (1000) and the second sub link part (1100) are rotated in accordance with movement of the first housing part or the second housing part, each conductive pattern of the second set of conductive patterns (1120) may maintain contact with the corresponding conductive pattern of the first set of conductive patterns (1020).

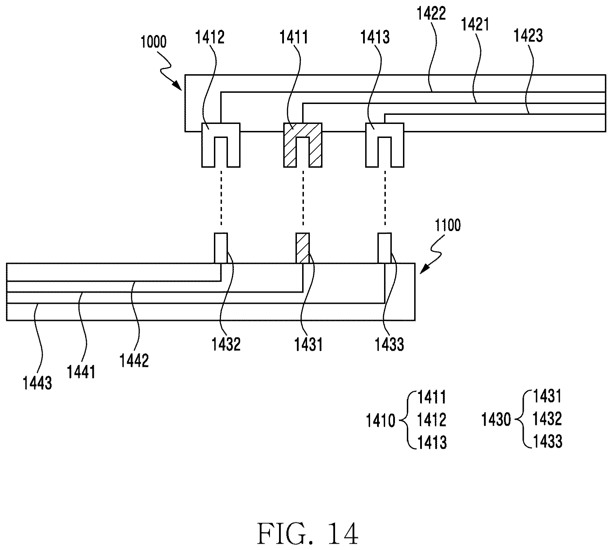

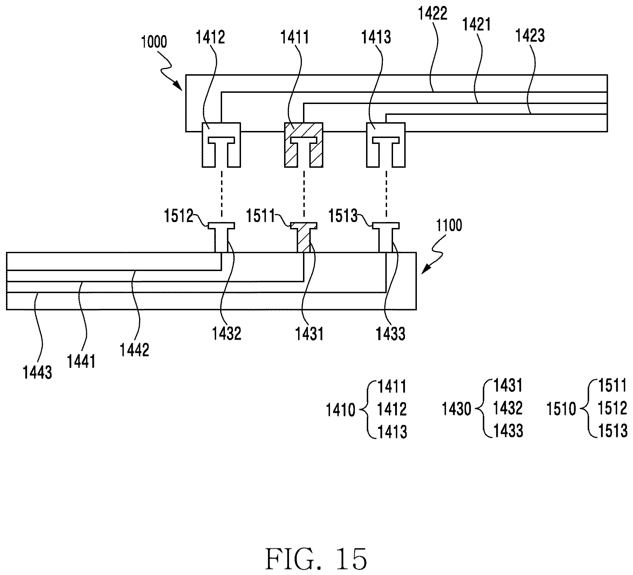

FIGS. 14 and 15 illustrate an example of cross sections of a first sub link part and a second sub link part.

Referring to FIG. 14, the first sub link part 1000 and the second sub link part 1100 may be coupled through terminals 1410 and 1430 (e.g. in providing contact between the first and second sub link parts). Since the first sub link part 1000 and the second sub link part 1100 rotate in a state of being coupled to each other, contact resistance may be caused at a contact portion between the first sub link part 1000 and the second sub link part 1100. The contact resistance may cause damage to the first sub link part 1000 or the second sub link part 1100, and may cause a change in characteristics of RF signals transmitted through the first sub link part 1000 and the second sub link part 1100, thereby causing noise or distortion of the RF signals. According to an embodiment, the first sub link part 1000 and the second sub link part 1100 may include terminals 1410 and 1430 to reduce the contact resistance.

According to an embodiment, the first sub link part 1000 may include a first terminal set 1410. The second sub link part 1100 may include a second set of terminals 1430 respectively coupled to a first set of terminals 1410. The first sub link part 1000 and the second sub link part 1100 may be electrically connected through the first set of terminals 1410 and the second set of terminals 1430. In terms of electrically connecting the first sub link part 1000 and the second sub link part 1100, the first set of terminals 1410 may correspond to the first set of conductive patterns 1020 of FIG. 10, and the second set of terminals 1430 may correspond to the second set of conductive patterns 1120 of FIG. 11.

In a case that the first sub link part 1000 and the second sub link part 1100 illustrated in FIG. 14 are a first sub link part 1000 and a second sub link part 1100 of a first link part (e.g., the first link part 631 of FIG. 9A), the first set of terminals 1410 may include a first terminal 1411 electrically connected to a ground of the electronic device 101, and second terminals 1412 and1413 electrically connected to a first set of signal lines (e.g., the first set of signal lines 910 of FIG. 9A) of a first PCB (e.g., the first PCB 611 of FIG. 9A). For example, the first terminal 1411 may correspond to a first ground portion of FIG. 10 (e.g., the first ground portion 1011 of FIG. 10), and the second terminals 1412 and 1413 may correspond to the first set of conductive patterns 1020 of FIG. 10. The first terminal 1411 may be connected to a ground line 1421 that is electrically connected to a ground layer of the first PCB 611. The second terminals 1412 and 1413 may be electrically connected to signal lines 1422 and 1423 that are electrically connected to the first set of signal lines 910 of the first PCB 611. For example, the signal line 1422 may be electrically connected to a first signal line (e.g., the first signal line 911 of FIG. 9A), and the signal line 1423 may be electrically connected to a second signal line (e.g., the second signal line 912 of FIG. 9A), but is not limited thereto.

For example, the second set of terminals 1430 may include a third terminal 1431 electrically connected to a ground of the electronic device 101, and fourth terminals 1432 and 1433 electrically connected to a second set of signal lines (e.g., the second set of signal lines 920 of FIG. 9A) of a second PCB (e.g., the second PCB 612 of FIG. 9A). For example, the third terminal 1431 may correspond to a second ground portion of FIG. 11 (e.g., the first ground portion 1111 of FIG. 11), and the fourth terminals 1432 and 1433 may correspond to the second set of conductive patterns 1120 of FIG. 11. The third terminal 1431 may be connected to a ground line 1441 that is electrically connected to a ground layer of the second PCB 612. The fourth terminals 1432 and 1433 may be electrically connected to signal lines 1442 and 1443 that are electrically connected to the second set of signal lines 920 of the second PCB 612. The number of the first set of terminals 1410 and the number of the second set of terminals 1430 may correspond to the number of signal lines included in an FPCB assembly (e.g., the FPCB assembly 510 of FIG. 6). For example, the signal line 1442 may be electrically connected to a first signal line (e.g., the fourth signal line 921 of FIG. 9A), and the signal line 1443 may be electrically connected to a fifth signal line (e.g., the fifth signal line 922 of FIG. 9A), but is not limited thereto.

The above descriptions may be substantially identically applied to a second link part (e.g., the second link part 632 of FIG. 9A) and a third link part (e.g., the third link part 633 of FIG. 9A). In a case that the first sub link part 1000 and the second sub link part 1100 illustrated in FIG. 14 are the first sub link part 1000 and the second sub link part 1100 of the second link part 632, the second terminals 1412 and 1413 may be electrically connected to the first set of signal lines 910 of the first PCB 611, and the fourth terminals 1432 and 1433 may be electrically connected to a third set of signal lines (e.g., the third set of signal lines 930 of FIG. 9A) of a third FPCB (e.g., the third FPCB 621 of FIG. 9A). In a case that the first sub link part 1000 and the second sub link part 1100 illustrated in FIG. 14 are the first sub link part 1000 and the second sub link part 1100 of the third link part 633, the second terminals 1412 and 1413 may be electrically connected to the second set of signal lines 920 of the second PCB 612, and the fourth terminals 1432 and 1433 may be electrically connected to a fourth set of signal lines (e.g., the fourth set of signal lines 940 of FIG. 9A) of a fourth FPCB (e.g., the fourth FPCB 622 of FIG. 9A).

According to an embodiment, when the first sub link part 1000 and the second sub link part 1100 are coupled, the first terminal 1411 and the third terminal 1431 may be coupled, and the second terminals 1412 and 1413 may be coupled to the fourth terminals 1432 and 1433, respectively. Through the coupling of the first terminal 1411 and the third terminal 1431, the ground lines 1421 and 1441 may be electrically connected to each other. Through the coupling of the second terminals 1412 and 1413 and the fourth terminals 1432 and 1433, signal lines 1422 and 1423 of the first sub link part 1000 and signal lines 1442 and 1444 of the second sub link part 1100 may be electrically connected, respectively. For example, a signal line 1422 of the first sub link part 1000 and a signal line 1442 of the second sub link part 1100 may be electrically connected through a coupling of a terminal 1412 of the first sub link part 1000 and a terminal 1432 of the second sub link part 1100, and another signal line 1423 of the first sub link part 1000 and another signal line 1443 of the second sub link part 1100 may be electrically connected through a coupling of another terminal 1413 of the first sub link part 1000 and another terminal 1433 of the second sub link part 1100. In FIG. 14, two second terminals 1412 and 1413 and two signal lines 1422 and 1423 of the first sub link part 1000, and two fourth terminals 1432 and 1433 and two signal lines 1442 and 1443 of the second sub link part 1100 are illustrated and described, respectively, but this is only for convenience of explanation, and the embodiments of the present disclosure are not limited thereto. For example, the number of terminals and signal lines included in the first sub link part 1000 and the second sub link part 1100 may correspond to the number of signal lines included in the FPCB assembly 510.

According to an embodiment, the second set of terminals 1430 may be inserted into the first set of terminals 1410. For example, each terminal of the first set of terminals 1410 may be in a form of a receptacle that accommodates a corresponding terminal of the second set of terminals 1430, and each terminal of the second set of terminals 1430 may be in a form of a header that is inserted into a corresponding terminal of the first set of terminals 1410. However, it is not limited thereto. Conversely, the first set of terminals 1410 may be in the form of a header, and the second set of terminals 1430 may be in the form of a receptacle. As the second set of terminals 1430 are inserted into the first set of terminals 1410, respectively, the second sub link part 1100 may be coupled to (e.g. in contact with) the first sub link part 1000. When the first sub link part 1000 is rotated with respect to the second sub link part 1100, the second set of terminals 1430 may be rotated in a state of being inserted into the first set of terminals 1410 (e.g. and maintaining the contact between the sub link parts, and the corresponding conductive patterns thereof). Through the structure, stable coupling between the first sub link part 1000 and the second sub link part 1100 may be possible, and the contact resistance may be reduced. As the contact resistance is reduced, the change in the characteristic of RF signals transmitted through the first sub link part 1000 and the second sub link part 1100 may be reduced.

Referring to FIG. 15, in order to improve coupling force between the first set of terminals 1410 and the second set of terminals 1430, the second set of terminals 1430 may include a flange portion 1510. For example, the area of an end portion of the second set of terminals 1430 on which the flange portion 1510 is formed may be formed to be larger than the area of another portion of the second set of terminals 1430 on which the flange portion is not formed. The first set of terminals 1410 may have a structure capable of accommodating the flange portion 1510. When the second set of terminals 1430 is inserted into the first set of terminals 1410, the first set of terminals 1410 and the second set of terminals 1430 may be firmly coupled by the flange portion 1510. A flange portion 1511 of the third terminal 1431 may be inserted into the first terminal 1411. Flange portions 1512 and 1513 of the fourth terminals 1432 and 1433 may be inserted into the second terminals 1412 and 1413, respectively.

For example, when the first set of terminals 1410 is in the form of a header and the second set of terminals 1430 is in the form of a receptacle, the first set of terminals 1410 may include a flange portion.

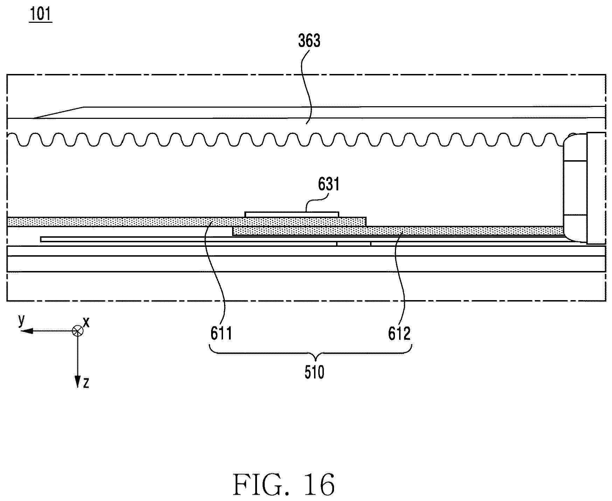

FIG. 16 is a side view of a X portion of FIG. 8.

Referring to FIG. 16, a driving mechanism 360 may include a rack gear 363. As described above, the rack gear 363 may extend parallel to a moving direction (e.g., in the y-axis direction) of a first housing part (e.g., the first housing part 210 of FIG. 8) or a second housing part (e.g., the second housing part 220 of FIG. 8). The FPCB assembly 510 may be positioned above the rack gear 363 (e.g., in the +z direction).

As described above, since a first PCB 611 of an FPCB assembly (e.g., the FPCB assembly 510 of FIG. 5) and a second PCB 612 of the FPCB assembly 510 are disposed parallel to a first PCB (e.g., the first PCB 410 of FIG. 5) and a second PCB (e.g., the second PCB 420 of FIG. 5), the first PCB 611 and the second PCB 612 may be disposed parallel to the rack gear 363. For example, the rack gear 363 may be disposed on the x-y plane and may move along the y-axis direction, and the first PCB 611 and the second PCB 612 may also be disposed on the x-y plane. As the first PCB 611 and the second PCB 612 are disposed parallel to the rack gear 363, a space occupied by the FPCB assembly 510 may be reduced, so a thickness of the electronic device 101 may be reduced.

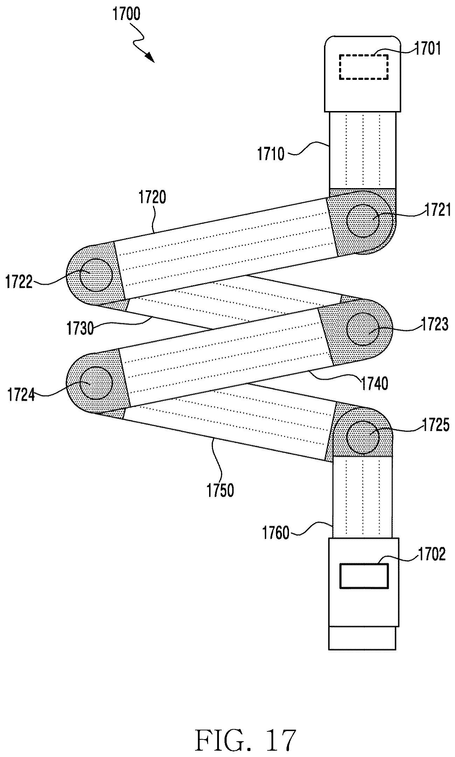

FIG. 17 illustrates an example of an FPCB assembly.

The above-described FPCB assembly (e.g., the FPCB assembly 510 of FIG. 9A) has been described as a structure including four PCBs (e.g., the first PCB 611 (or first assembly PCB), the second PCB (or second assembly PCB) 612, the third FPCB 621, and the fourth FPCB 622 of FIG. 9A), but the embodiments of the present disclosure are not limited thereto. The number, length, and structure of segments included in the FPCB assembly may be implemented in various ways according to a size of an electronic device (e.g., the electronic device 101 of FIG. 6), structure, the number of signal lines, or an arrangement relationship of other components of the electronic device. For example, when a sliding length of a second housing part (e.g., the second housing part 220 of FIG. 6) with respect to a first housing part (e.g., the first housing part 210 of FIG. 6) increases, the number of segments included in the FPCB assembly may increase. The number of one or more link parts may be determined according to the number of each segment of the FPCB assembly.

Referring to FIG. 17, the FPCB assembly 1700 may include six FPCBs. For example, the FPCB assembly 1700 may include a first FPCB 1710, a second PCB 1720, a third PCB 1730, a fourth PCB 1740, a fifth PCB 1750, and a sixth FPCB 1760.

For example, the first FPCB 1710 of the FPCB assembly 1700 may include a first connector 1701 connected to a first PCB (e.g., the first PCB 410 of FIG. 6). The first FPCB 1710 may be connected to and fixed to the first PCB 410 through the first connector 1701. The sixth FPCB 1760 may include a second connector 1702 connected to a second PCB (e.g., the second PCB 420 of FIG. 6). The sixth FPCB 1760 may be connected to and fixed to the second PCB 420 through the second connector 1702.

For example, the second PCB 1720 of the FPCB assembly 1700 may be rotatably connected to the first FPCB 1710 and the third PCB 1730. The first FPCB 1710 and the second PCB 1720 may be rotatably connected through a first link part 1721. The second PCB 1720 and the third PCB 1730 may be rotatably connected through a second link part 1722.

For example, the third PCB 1730 of the FPCB assembly 1700 may be rotatably connected to the second PCB 1720 and the fourth PCB 1740. The third PCB 1730 and the fourth PCB 1740 may be rotatably connected through a third link part 1723.

For example, the fourth PCB 1740 of the FPCB assembly 1700 may be rotatably connected to the third PCB 1730 and the fifth PCB 1750. The fourth PCB 1740 and the fifth PCB 1750 may be rotatably connected through a fourth link part 1724.

For example, the fifth PCB 1750 of the FPCB assembly 1700 may be rotatably connected to the fourth PCB 1740 and the sixth FPCB 1760. The fifth PCB 1750 and the sixth FPCB 1760 may be rotatably connected through a fifth link part 1725.

When a state of the electronic device 101 is changed, the second PCB 1720 of the FPCB assembly 1700, the third PCB 1730 of the FPCB assembly 1700, the fourth PCB 1740 of the FPCB assembly 1700, and the fifth PCB 1750 of the FPCB assembly 1700 may be rotated. As a distance between the first PCB 410 and the second PCB 420 is changed, the second PCB 1720, the third PCB 1730, the fourth PCB 1740, and the fifth PCB 1750 are rotated, so the FPCB assembly 1700 may be connected to the first PCB 410 and the second PCB 420, respectively. In addition to the FPCB assembly 1700 illustrated in FIG. 17, various embodiments may be possible.

According to an embodiment, the FPCB assembly 1700 may have a arrangement structure for reducing a thickness. For example, the first FPCB 1710, the third PCB 1730, and the fifth PCB 1750 may be disposed on the same plane (e.g., the first plane). The second PCB 1720, the fourth PCB 1740, and the sixth FPCB 1760 may be disposed on the same plane (e.g., the second plane). The first plane may be positioned below the second plane (e.g., in the -z direction).

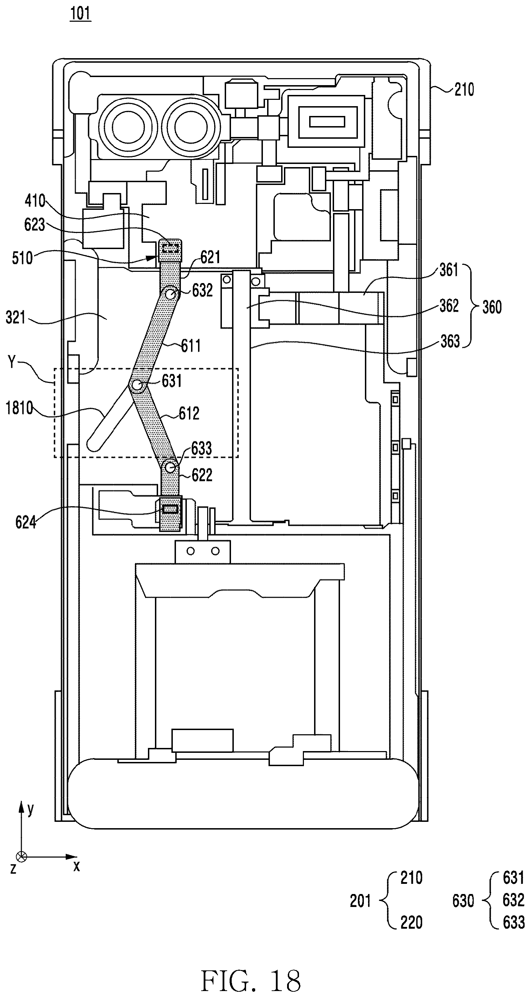

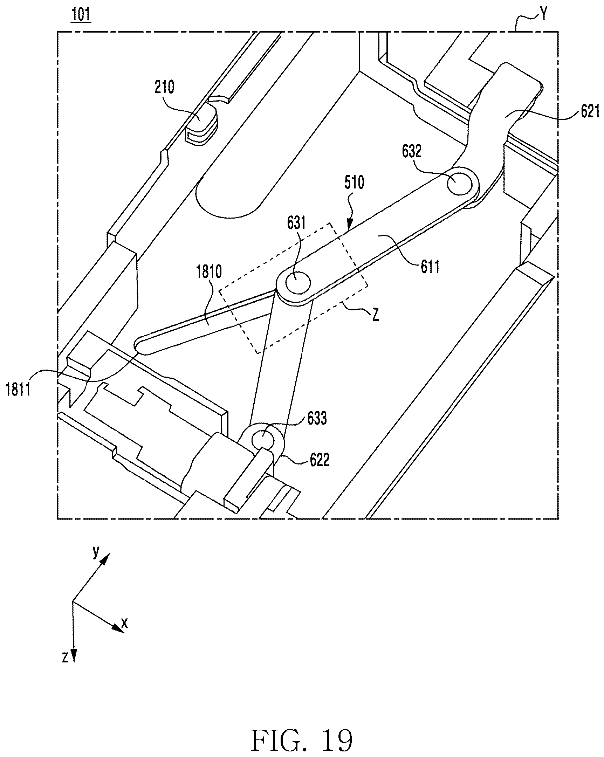

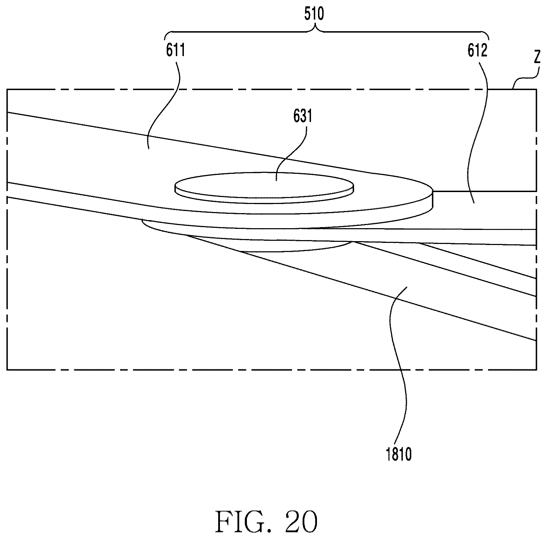

FIG. 18 illustrates an electronic device including a guide groove according to an embodiment. FIG. 19 is an enlarged view of a Y portion of FIG. 18. FIG. 20 is an enlarged view of a Z portion of FIG. 19.

Referring to FIG. 18, an electronic device 101 according to an embodiment may include at least one guide groove 1810. The at least one guide groove 1810 may be formed on a surface of a first bracket 321 of a first housing part 210, but is not limited thereto.

According to an embodiment, at least one link part (e.g., the first link part 631) among one or more link parts 630 may be inserted into the at least one guide groove 1810. For example, as illustrated in FIG. 18, the first link part 631 may be inserted into the at least one guide groove 1810. The at least one guide groove 1810 may be configured to guide movement of the inserted first link part 631. The first link part 631 may move along the at least one guide groove 1810.

As described above, when a state of the electronic device 101 is changed, an arrangement relationship of the first PCB 611 of the FPCB assembly 510 and the second PCB 612 of the FPCB assembly 510 may be changed. In order to change the arrangement relationship of the first PCB 611 and the second PCB 612, a position of the first link part 631 may be changed.

Referring to FIGS. 19 and 20, at least one guide groove 1810 may guide movement of at least one link part (e.g., the first link part 631) inserted into the at least one guide groove 1810, so that the at least one link part may move along a designated path. For example, in a second state of the electronic device 101 illustrated in FIG. 19, the first link part 631 may be contacted with an end portion of at least one guide groove 1810. While the state of the electronic device 101 is changed from the second state to the first state, the first PCB 611 of the FPCB assembly 510 and the second PCB 612 of the FPCB assembly 510 may be rotated. As described above, while the state of the electronic device 101 is changed from the second state to the first state, an angle between the first PCB 611 and the second PCB 612 may be reduced. In order for the angle to be reduced and the first PCB 611 and the second PCB 612 to be closer, the first link part 631 should move in a diagonal direction (e.g., a direction between the -x direction and the -y direction). The at least one guide groove 1810 may be formed in the diagonal direction, and a portion of the first link part 631 may be inserted into the at least one guide groove 1810 and move along the at least one guide groove 1810. While the state of the electronic device 101 is changed from the second state to the first state, the first link part 631 may move along the at least one guide groove 1810 toward another end portion 1811 of the at least one guide groove 1810. A length of the at least one guide groove 1810 may correspond to a movement distance of the at least one link part inserted into the at least one guide groove 1810. For example, when the electronic device 101 becomes the first state, the first link part 631 may be contacted with the other end portion 1811.

According to an embodiment, at least one link part, which is inserted into the at least one guide groove 1810 among one or more link parts 630, may move along a path designated by the at least one guide groove 1810, so the FPCB assembly 510 may operate within a designated range, and a rotation of the first PCB 611 of the FPCB assembly 510 and a rotation of the second PCB 612 of the FPCB assembly 510 may be controlled.

In FIG. 18, the at least the guide groove 1810 is illustrated as including only one guide groove 1810, but embodiments of the present disclosure are not limited thereto. For example, when the electronic device 101 includes the FPCB assembly 1700 illustrated in FIG. 17, a second link part (e.g., the second link part 1722 of FIG. 17) and a fourth link part (e.g., the fourth link part 1724 of FIG. 17) may be inserted into guide grooves, respectively. In this case, the at least one guide groove 1810 may be provided in plural.

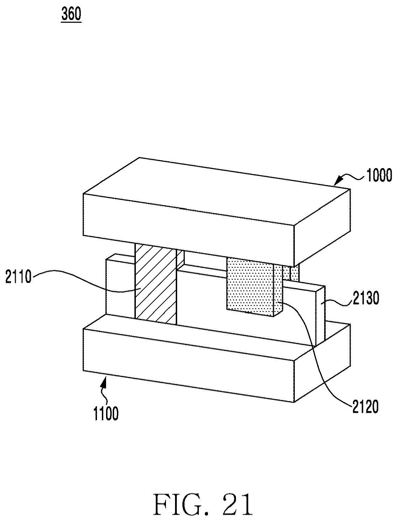

FIG. 21 illustrates a portion of a first sub link part and a second sub link part.

Referring to FIG. 21, one or more link parts (e.g., the one or more link parts 630 of FIG. 6) may include a stopper 2110 for limiting a rotation of the one or more link parts 630. For example, limiting the rotation of the one or more link parts 630 may be referred to as limiting a rotation amount (or rotation angle) of the one or more link parts 630 to a range within which contact between a first conductive pattern 2120 and a second conductive pattern 2130 is maintained. Hereinafter, for convenience of explanation, it is described that the first sub link part 1000 is rotated with respect to the second sub link part 1100, but as described above, the embodiments of the present disclosure are not limited thereto. When the first sub link part 1000 is rotated with respect to the second sub link part 1100, the stopper 2110 may limit the rotation amount (or rotation angle) of the first sub link part 1000 to a rotation range in which contact between the first conductive pattern 2120 and the second conductive pattern 2130 may be maintained. For example, a first conductive pattern 2120 may correspond to one of a first conductive set (e.g., the first conductive set 1020 of FIG. 10), and a second conductive pattern 2130 may correspond to one of a second conductive set (e.g., the second conductive set 1120 of FIG. 11).

Referring to FIG. 21, the stopper 2110 may be disposed between the first sub link part 1000 and the second sub link part 1100. When the first sub link part 1000 is rotated with respect to the second sub link part 1100, the first conductive pattern 2120 may move in contact with the second conductive pattern 2130.

For example, when the first sub link part 1000 is rotated counterclockwise with respect to the second sub link part 1100, the first conductive portion 2120 may move to a position in contact with the stopper 2110. When the first conductive portion 2120 is contacted with the stopper 2110, the first conductive portion 2120 is blocked by the stopper 2110, movement of the first conductive portion 2120 may be limited. Since a position of the stopper 2110 is spaced from an end portion of the second conductive portion 2130 of the second sub link part 1100 corresponding to the first conductive portion 2120 of the first sub link part 1000, the first conductive portion 2120 may be contacted with the second conductive portion 2130 at a position where the first conductive portion 2120 is contacted with the stopper 2110. The stopper 2110 may limit the amount of movement of the first conductive portion 2120 to within a range where the first conductive portion 2120 may maintain contact with the second conductive portion 2130.

In FIG. 21, the stopper 2110 is disposed to overlap with the second conductive portion 2130, but embodiments of the present disclosure are not limited thereto. For example, the stopper 2110 may be positioned within a non-conductive pattern (e.g., the fourth non-conductive pattern 1131, the fifth non-conductive pattern 1132, and the sixth non-conductive pattern 1133 of FIG. 11) of the second sub link part 1100. A width of the stopper 2110 may be smaller than or equal to a circumference of the non-conductive pattern.

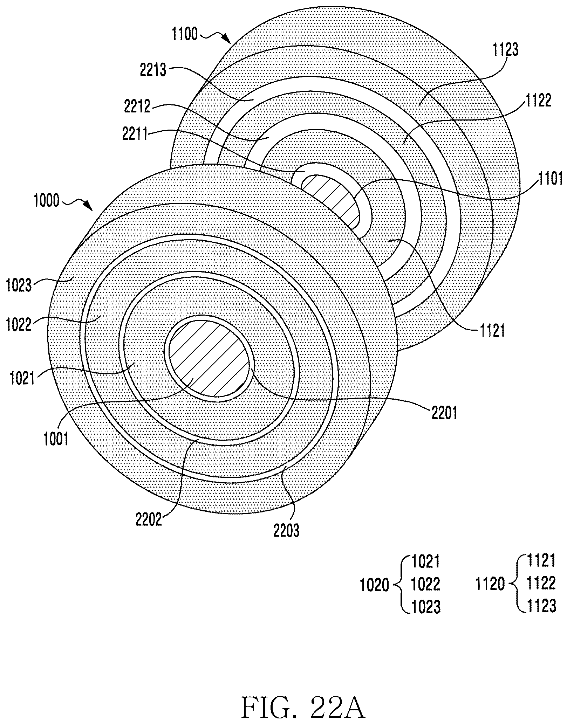

FIG. 22A illustrates a first sub link part and a second sub link part, according to an embodiment.

In the above description, it is described that a structure in which a circumference of each conductive pattern of the first set of conductive patterns 1020 and a circumference of each conductive pattern of the second set of conductive patterns 1120 are formed differently to maintain contact between the first set of conductive patterns 1020 and the second set of conductive patterns 1120 when the first sub link part 1000 or the second sub link part 1100 rotates, but the embodiments of the present disclosure are not limited thereto. In the description of the structure illustrated in FIG. 22A, the expression 'a component surrounds another component' may refer to as a structure in which the component surrounds a periphery without contacting the other component.

Referring to FIG. 22A, the first sub link part 1000 may include a first set of conductive patterns 1020 that are spaced apart from a first core portion 1001 electrically connected to a ground of an electronic device (e.g., the electronic device 101 of FIG. 6) and have a concentric shape corresponding to the first core portion 1001. For example, the first set of conductive patterns 1020 may include a first conductive pattern 1021 spaced apart from the first core portion 1001 and surrounding the first core portion 1001, a second conductive pattern 1022 spaced apart from the first conductive pattern 1021 and surrounding the first conductive pattern 1021, and a third conductive pattern 1023 spaced apart from the second conductive pattern 1022 and surrounding the second conductive pattern 1022.

According to an embodiment, the second sub link part 1100 may include a second set of conductive patterns 1120 that are spaced apart from a second core portion 1101 contacting with the first core portion 1001 and have a concentric shape corresponding to the second core portion 1101. For example, the second set of conductive patterns 1120 may include a fourth conductive pattern 1121, spaced apart from the second core portion 1101, surrounding the second core portion 1101, and contacting with the first conductive pattern 1021, a fifth conductive pattern 1122 spaced apart from the fourth conductive pattern 1121, surrounding the fourth conductive pattern 1121, and contacting with the second conductive pattern 1022, and a sixth conductive pattern 1123 spaced apart from the fifth conductive pattern 1122, surrounding the fifth conductive pattern 1122, and contacting with the third conductive pattern 1023.

According to an embodiment, the first core portion 1001, the first conductive pattern 1021, the second conductive pattern 1022, and the third conductive pattern 1023 may be spaced apart from each other. For example, the first sub link part 1000 may include a first non-conductive pattern 2201 disposed between the first core portion 1001 and the first conductive pattern 1021, a second non-conductive pattern 2202 disposed between the first conductive pattern 1021 and the second conductive pattern 1022, and a third non-conductive pattern 2203 disposed between the second conductive pattern 1022 and the third conductive pattern 1023. The first non-conductive pattern 2201 may be disposed between the first core portion 1001 and the first conductive pattern 1021, and thus physically separate the first core portion 1001 and the first conductive pattern 1021, which are electrically connected to the ground. The second non-conductive pattern 2202 may physically separate the first conductive pattern 1021 and the second conductive pattern 1022. The third non-conductive pattern 2203 may physically separate the second conductive pattern 1022 and the third conductive pattern 1023.

According to an embodiment, the second core portion 1101, the fourth conductive pattern 1121, the fifth conductive pattern 1122, and the sixth conductive pattern 1123 may be spaced apart from each other. For example, the second sub link part 1100 may include a fourth non-conductive pattern 2211 disposed between the second core portion 1101 and the fourth conductive pattern 1121, a fifth non-conductive pattern 2212 disposed between the fourth conductive pattern 1121 and the fifth conductive pattern 1122, and a sixth non-conductive pattern 2213 disposed between the fifth conductive pattern 1122 and the sixth conductive pattern 1123. The fourth non-conductive pattern 2211 may be disposed between the second core portion 1101 and the fourth conductive pattern 1021, and thus physically separate the second core portion 1101 and the fourth conductive pattern 1121, which are electrically connected to the ground. The fifth non-conductive pattern 2212 may physically separate the fourth conductive pattern 1121 and the fifth conductive pattern 1122. The sixth non-conductive pattern 2213 may physically separate the fifth conductive pattern 1122 and the sixth conductive pattern 1123.

Even when the first sub link part 1000 and the second sub link part 1100 illustrated in FIG. 22A are rotated, the conductive patterns are formed in a concentric shape, so an electrical connection between the first set of conductive patterns 1020 and the second set of conductive patterns 1120 may be maintained. For example, in a case of a first link part (e.g., the first link part 631 of FIG. 9A), an electrical connection between the first set of signal lines 910 of the first PCB 611 and the second set of signal lines 920 of the second PCB 612 may be stably formed through the structure.

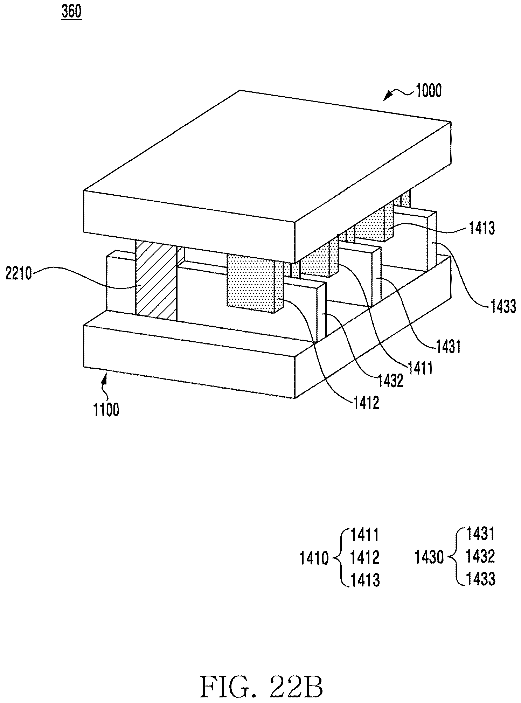

FIG. 22B illustrates a portion of a first sub link part and a second sub link part.

FIG. 22B illustrates an example in which the first sub link part 1000 and the second sub link part 1100 of FIG. 22A include a terminal. For example, a first terminal 1411 of the first sub link part 1000 may correspond to the first core portion 1001 of FIG. 22A. Second terminals 1412 and 1413 of the first sub link part 1000 may correspond to the first conductive pattern 1021 and the second conductive pattern 1022 of FIG. 22A, respectively. A third terminal 1431 of the second sub link part 1100 may correspond to the second core portion 1101 of FIG. 22A. Second terminals 1432 and 1433 of the second sub link part 1100 may correspond to the fourth conductive pattern 1121 and the fifth conductive pattern 1122 of FIG. 22A, respectively. For convenience of explanation, the first sub link part 1000 and the second sub link part 1100 are illustrated in FIG. 22B as each including three terminals, but the embodiments of the present disclosure are not limited thereto. For example, the number of terminals of the first sub link part 1000 may correspond to the number of the first conductive set 1020 of FIG. 22A, and the number of terminals of the second sub link part 1100 may correspond to the number of the second conductive set 1120 of FIG. 22A.

Referring to FIG. 22B, one or more link parts (e.g., the one or more link parts 630 of FIG. 6) may include a stopper 2210 for limiting a rotation of the one or more link parts 630. For example, limiting the rotation of the one or more link parts 630 may be referred to as limiting the amount of rotation (or rotation angle) of the one or more link parts 630 to a range where contact between the first set of terminals 1410 and the second set of terminals 1430 is maintained. Hereinafter, for convenience of explanation, it is described that the first sub link part 1000 is rotated with respect to the second sub link part 1100, but as described above, embodiments of the present disclosure are not limited thereto. When the first sub link part 1000 is rotated with respect to the second sub link part 1100, the stopper 2210 may limit the amount of rotation (or rotation angle) of the first sub link part 1000 within a rotation range in which contact between the first set of terminals 1410 and the second set of terminals 1430 may be maintained.

Referring to FIG. 22B, the stopper 2210 may be disposed between the first sub link part 1000 and the second sub link part 1100. When the first sub link part 1000 is rotated with respect to the second sub link part 1100, the first set of terminals 1410 may move in contact with the second set of terminals 1430, respectively. For example, the first terminal 1411 may move in contact with the third terminal 1431, and the second terminals 1412 and 1413 may move in contact with the fourth terminals 1432 and 1433, respectively. The stopper 2210 may be disposed at a position spaced apart from an end portion of the second set of terminals 1430 by a certain distance toward the first set of terminals 1410.

For example, when the first sub link part 1000 is rotated counterclockwise with respect to the second sub link part 1100, a terminal 1412 may move to a position contacted with the stopper 2210. When the terminal 1412 is contacted with the stopper 2210, the terminal 1412 is blocked by the stopper 2210, so the movement of the terminal 1412 may be limited. Since a position of the stopper 2210 is spaced apart from an end portion of a terminal 1432 of the second sub link part 1100 corresponding to the terminal 1412 of the first sub link part 1000, the terminal 1412 may be contacted with the terminal 1432 at a position where the terminal 1412 is contacted with the stopper 2210. Although not shown, one or more of the link parts 630 may include another stopper adjacent to another end portion of the terminal 1432 and/or another stopper for limiting movement of a first terminal 1411 or another terminal 1413 of the first sub link part 1000. The first set of terminals 1410 may move between stoppers spaced apart from two end portions of the second set of terminals 1430, so the first set of terminals 1410 may move within a range where contact with the second set of terminals 1430 is maintained without leaving the second set of terminals 1430. The electrical connection between the first sub link part 1000 and the second sub link part 1100 may be maintained by maintaining the contact.

According to an embodiment, the stopper 2210 may be positioned within a non-conductive pattern (e.g., the fourth non-conductive pattern 1131, the fifth non-conductive pattern 1132, and the sixth non-conductive pattern 1133 of FIG. 11) of the second sub link part 1100. A width of the stopper 2110 may be smaller than or equal to a circumference of the non-conductive pattern.

FIG. 23 illustrates an electronic device according to an embodiment.

Antenna radiators of the electronic device 101 may be formed as a portion of a periphery of the second housing part 220. For example, a portion of a periphery of the second housing part 220 (e.g. an edge portion of the second housing part 220) may be configured to function as an antenna radiator.

Referring to FIG. 23, the second housing part 220 may include a first peripheral portion 220a, a second peripheral portion 220b, and a third peripheral portion 220c. The first peripheral portion 220a may extend parallel to a moving direction of the second housing part 220 with respect to the first housing part 210. The second peripheral portion 220b may be vertically connected to the first peripheral portion 220a. The third peripheral portion 220c may be opposite to the first peripheral portion 220a. For example, the first peripheral portion 220a and the third peripheral portion 220c may be parallel to the y-axis of FIG. 5. For example, the second peripheral portion 220b may be parallel to the x-axis of FIG. 5. For example, the second peripheral portion 220b may extend from a lower portion of the first peripheral portion 220a to a lower portion of the third peripheral portion. Although not illustrated in FIG. 5, the second housing part 220 may have a fourth peripheral portion covered by the first housing part 210 and a flexible display.

According to an embodiment, the second housing part 220 may include a conductive portion 2320 configured to function as an antenna radiator. The conductive portion 2320, which is a physical component of an antenna, may be configured to radiate and/or receive electromagnetic waves by being fed by wireless communication circuitry (e.g., the wireless communication module 192 of FIG. 1). For example, the wireless communication circuitry 192 may be configured to communicate with an external electronic device by feeding a feed point of the conductive portion 2320. When the feed point of the conductive portion 2320 is fed, a current (e.g., a radiation current) may flow along the conductive portion 2320. The current may form an electromagnetic wave around the conductive portion 2320, and radio frequency (RF) signals may be radiated or received through the electromagnetic wave.

According to an embodiment, the second housing part 220 may include a non-conductive portion. For example, the non-conductive portion may be formed of a non-conductive material. The non-conductive portion may be contacted with an end portion of the conductive portion 2320, thereby determining (or limiting) a length of the conductive portion 2320. For example, an end of the conductive portion 2320 and another end of the conductive portion 2320 may be contacted with the non-conductive portion. For example, the second housing part 220 may include a first non-conductive portion 2311 and a second non-conductive portion 2312 disposed within the second peripheral portion 220b, a third non-conductive portion 2313 disposed within the first peripheral portion 220a, and/or a fourth non-conductive portion 2314 disposed within the third peripheral portion 220c.

According to an embodiment, the second housing part 220 may include a first conductive portion 2321, a second conductive portion 2322, and/or a third conductive portion 2322. The first conductive portion 2321 may be referred to as a first antenna radiator (e.g., the first antenna radiator 521 of FIG. 5). The second conductive portion 2322 may be referred to as a second antenna radiator (e.g., the second antenna radiator 522 of FIG. 5). The third conductive portion 2323 may be referred to as a third antenna radiator (e.g., the third antenna radiator 523 of FIG. 5).

For example, the first conductive portion 2321 may be formed between the first non-conductive portion 2311 and the second non-conductive portion 2312, within the second peripheral portion 220b. The second conductive portion 2322 may be formed between the third non-conductive portion 2313 within the first peripheral portion 220a and the first non-conductive portion 2311 within the second peripheral portion 220b. The third conductive portion 2323 may be formed between the second non-conductive portion 2312 within the second peripheral portion 220b and the fourth non-conductive portion 2314 within the third peripheral portion 220c.

A structure of the second housing part 220 illustrated in FIG. 23 should be understood as an example for explaining the conductive portion 2320 used as an antenna radiator, and the embodiments of the present disclosure are not limited to the structure illustrated in FIG. 23. The electronic device 101 may be configured to communicate with an external electronic device by using antenna radiators formed as a portion of a periphery of the second housing part 220. As described above, wireless communication circuitry (e.g., the wireless communication module 192 of FIG. 1) may be disposed on a first PCB (e.g., the first PCB 410 of FIG. 6) disposed within the first housing part 210, and the conductive portion 2320 of the second housing part 220 configured to function as an antenna radiator may be electrically connected to a second PCB (e.g., the second PCB 420 of FIG. 7) within the second housing part 220. As the first PCB 410 and the second PCB 420 are electrically connected by an FPCB assembly (e.g., the FPCB assembly 510 of FIG. 6), the wireless communication circuitry 192 and the conductive portion 2320 may be electrically connected.

The technical problems to be achieved in this document are not limited to those described above, and other technical problems not mentioned herein will be clearly understood by those having ordinary knowledge in the art to which the present disclosure belongs, from the following description.

An electronic device 101 is provided. The electronic device 101 may comprise a housing 201 including a first housing part 210 and a second housing part 220 movably coupled to each other. The electronic device 101 may comprise a first printed circuit board (PCB) 410 disposed in the first housing part 210. The electronic device 101 may comprise a second PCB 420 disposed in the second housing part 220. The electronic device 101 may include a flexible printed circuit board (FPCB) assembly 510 configured to electrically connect the first PCB 410 and the second PCB 420. The FPCB assembly 510 may include a first PCB 611 where a first set of signal lines 910 transmitting a plurality of signals are formed (e.g. a first PCB comprising a first set of signal lines for transmitting a plurality of signals), a second PCB 612 where a second set of signal lines 920 transmitting the plurality of signals are formed (e.g. a second PCB comprising a second set of signa lines for transmitting the plurality of signals), and at least one link part (e.g., the first link part 631 of FIG. 6) rotatably connecting the first PCB 611 of the FPCB assembly 510 and the second PCB 612 of the FPCB assembly 510. The at least one link part may include a first sub link part 1000 and a second sub link part 1100 rotatably coupled to each other. The first sub link part 1000 may include first set of conductive patterns 1020 electrically connected to the first set of signal lines 910, respectively. The second sub link part 1100 may include a second set of conductive patterns 1120 electrically connected to the second set of signal lines 920, respectively. Each conductive pattern of the first set of conductive patterns 1020 and each conductive pattern of the second set of conductive patterns 1120 may be configured to be electrically connected to each other. An electrical connection between each conductive pattern of the first set of conductive patterns 1020 and each conductive pattern of the second set of conductive patterns 1120 may also be configured to be maintained, while at least one of the first sub link part 1000 and the second sub link part 1100 rotates.

According to an embodiment, when the second sub link part 1100 is coupled to the first sub link part 1000, each conductive pattern of the second set of conductive patterns is configured to contact the respective conductive pattern of the first set of conductive patterns to provide the connection (e.g. to electrically connect) the first set and second set of conductive patterns.

According to an embodiment, the first sub link part or the second sub link part, is configured to rotate in accordance with movement of the first housing part or the second housing part.

According to an embodiment, a length of each conductive pattern of the second set of conductive patterns is longer than the length of each respective conductive pattern of the first set of conductive patterns to which it is electrically connected, such that the contact is maintained with the corresponding conductive pattern of the first set of conductive patterns when the first sub link part or the second sub link part is rotated in accordance with movement of the first housing part or the second housing part.

According to an embodiment, the first PCB 410, the second PCB 420, the first PCB 611 (e.g. the first assembly PCB) of the FPCB assembly 510, and the second PCB 612 (e.g. the second assembly PCB) of the FPCB assembly 510 may be disposed substantially parallel to each other. For example, the first PCB 410, the second PCB 420, the first PCB 611, and the second PCB 612 may be disposed to face substantially the same direction.

According to an embodiment, the electronic device 101 may include wireless communication circuitry 192 disposed on the first PCB 410 (e.g. the first PCB 410 disposed in the first housing part). The electronic device 101 may further include one or more antenna radiators 521, 522, and 523 electrically connected to the second PCB 420 (e.g. the second PCB disposed in the second housing part). The FPCB assembly may be configured to transmit radio frequency (RF) signals from the wireless communication circuitry 192 disposed on the first PCB 410 to the one or more antenna radiator 521, 522, and 523 electrically connected to the second PCB 420, through the first set of signal lines 910 and the second set of signal lines 920.

According to an embodiment, the one or more antenna radiators 521, 522, and 523 may define at least a portion of a periphery of the second housing part 220.

According to an embodiment, the first sub link part 1000 may include a first core portion 1001 electrically connected to a ground of the electronic device 101 and a first peripheral portion 1002 surrounding the first core portion 1001. The first set of conductive patterns 1020 may be disposed on the first peripheral portion 1002. The second sub link part 1100 may include a second core portion 1101 contacted with the first core portion 1001, and a second peripheral portion 1102 surrounding the second core portion 1101. The second set of conductive patterns 1120 may be disposed on the second peripheral portion 1102. For example, a portion of the first peripheral portion 1002 may be defined by the first set of conductive patterns 1020, and a portion of the second peripheral portion 1102 may be defined by the second set of conductive patterns 1120.

According to an embodiment, the first sub link part 1000 or the second sub link part 1100 may be configured to rotate according to the movement of the first housing part 210 or the second housing part 220.

According to an embodiment, the first set of conductive patterns 1020 may include a first conductive pattern 1021 defining a first region 1041 of the first peripheral portion 1002. The first set of conductive patterns 1020 may include a second conductive pattern 1022 defining a second region 1042 of the first peripheral portion 1002 spaced apart from the first region 1041 of the first peripheral portion 1002. The second set of conductive patterns 1120 may include a third conductive pattern 1121, contacted with the first conductive pattern 1021, defining a third region 1043 of the second peripheral portion 1102 contacted with the first region 1041 of the first peripheral portion 1002. The second set of conductive patterns 1120 may a fourth conductive pattern 1122, contacted with the second conductive pattern 1022, defining a fourth region 1141 of the second peripheral portion 1102, wherein the fourth region 1141 is spaced apart from the third region 1043 of the second peripheral portion 1102 and is contacted with the second region 1102 of the first peripheral portion 1002.

According to an embodiment, each conductive pattern of the second set of conductive patterns 1120 may be contacted with the corresponding conductive pattern of the first set of conductive patterns 1020 when the second sub link part 1100 is coupled to the first sub link part 1000. Each conductive pattern of the second set of conductive patterns 1120 may be configured to be electrically connected to the corresponding conductive pattern of the first set of conductive patterns 1020, by maintaining contact with the corresponding conductive pattern of the first set of conductive patterns 1020, when the first sub link part 1000 or the second sub link part 1100 is rotated in accordance with movement of the first housing part 210 or the second housing part 220.

According to an embodiment, a first circumference (e.g. a length corresponding to a circumferential portion of the circumference of the peripheral portion) of the first region 1041 may be shorter than a third circumference (e.g. a length corresponding to a circumferential portion of the circumference of the peripheral portion) of the third region 1043. A second circumference of the second region 1042 may be shorter than a fourth circumference of the fourth region 1141.

According to an embodiment, the first set of signal lines 910 may include a first signal line 911 for transmitting a first RF signal on a first frequency band. The first set of signal lines 910 may include a second signal line 912 for transmitting a second RF signal on a second frequency band different from the first frequency band. The second set of signal lines 920 may include a third signal line 913 for transmitting the first RF signal. The second set of signal lines 920 may include a fourth signal line 921 for transmitting the second RF signal. The first set of conductive patterns 1020 may include a first conductive pattern 1021 electrically connected to the first signal line 911. The first set of conductive patterns 1020 may include a second conductive pattern 1022 electrically connected to the second signal line 912. The second set of conductive patterns 1120 may include a third conductive pattern 1121 electrically connected to the third signal line 913 and the first conductive pattern 1021. The second set of conductive patterns 1120 may include a fourth conductive pattern 1122 electrically connected to the fourth signal line 921 and the second conductive pattern 1022.

According to an embodiment, the at least one link part may be configured to move according to the movement of the first housing part 210 or the second housing part 220. The electronic device 101 may include a guide groove 1810 into which the at least one link part is inserted, configured to guide the movement of the at least one link part.

According to an embodiment, the at least one link part may include a stopper 2110 to limit amount of rotation of the at least one link part.

According to an embodiment, the first sub link part 1000 may include a first core portion 1001 electrically connected to a ground of the electronic device 101. The first sub link part 1000 may include a first conductive pattern 1021 spaced apart from the first core portion 1001 and surrounding the first core portion 1001. The first sub link part 1000 may include a second conductive pattern 1022 spaced apart from the first conductive pattern 1021 and surrounding the first conductive pattern 1021. The second sub link part 1100 may include a second core portion 1101 electrically connected to the ground of the electronic device 101. The second sub link part 1100 may include a third conductive pattern 1121, spaced apart from the second core portion 1101, surrounding the second core portion 1101, and electrically connected to the first conductive pattern 1021. The second sub link part 1100 may include a fourth conductive pattern 1122, spaced apart from the third conductive pattern 1023, surrounding the third conductive pattern 1023, and electrically connected to the second conductive pattern 1022.

According to an embodiment, the electronic device 101 may further include a driving mechanism 360 configured to move the first housing part 210 or the second housing part 220. The driving mechanism 360 may include a motor 361, a pinion gear 362 coupled to a rotational axis of the motor 361, and a rack gear 363 engaged with the pinion gear 362, coupled to the first housing part 210 or the second housing part 220. The first PCB 611 of the FPCB assembly 510 and the second PCB 612 of the FPCB assembly 510 may be disposed parallel to the rack gear 363.

According to an embodiment, the FPCB assembly 510 may further include a third FPCB 621 connected to the first PCB 410 and rotatably connected to the first PCB 611 of the FPCB assembly 510. The FPCB assembly 510 may further include a fourth FPCB 622 connected to the second PCB 420 and rotatably connected to the second PCB 612 of the FPCB assembly 510. The at least one link part may include a first link part 631 rotatably connecting an end portion of the first PCB 611 and an end portion of the second PCB 612. The FPCB assembly 510 may include a second link part 632 rotatably connecting another end portion of the first PCB 611 and an end portion of the third FPCB 621, and a third link part 633 rotatably connecting another end portion of the second PCB 612 and an end portion of the fourth FPCB 622.

An electronic device 101 is provided. The electronic device 101 may comprise a housing 201 including a first housing part 210 and a second housing part 220 movably coupled to the first housing part 210. The electronic device 101 may comprise a flexible display 230 configured to be at least partially bent based on movement of the second housing part 220 with respect to the first housing part 210. The electronic device 101 may comprise a first PCB 410 disposed within the first housing part 210. The electronic device 101 may comprise a second PCB 420 disposed within the second housing part 220. The electronic device 101 may comprise an FPCB assembly 510 configured to electrically connect the first PCB 410 and the second PCB 420. The FPCB assembly 510 may include a first PCB 611, a second PCB 612, and one or more link parts 630 rotatably connecting the first PCB 611 of the FPCB assembly 510 and the second PCB 612 of the FPCB assembly 510. Each of the one or more link parts 630 may include a first sub link part 1000 including a first set of conductive patterns 1020 and connected to the first PCB 611 of the FPCB assembly 510. Each of the one or more link parts 630 may include a second sub link part 1100, including a second set of conductive patterns 1120 electrically connected to a corresponding conductive pattern of the first set of conductive patterns 1020, respectively, rotatably coupled to the first sub link part 1000, and connected to the second PCB 612. The first sub link part 1000 and the second sub link part 1100 may be configured to rotate the first PCB 611 of the FPCB assembly 510 and the second PCB 612 of the FPCB assembly 510, by rotating according to the movement of the second housing part 220.

According to an embodiment, the first sub link part 1000 may include a first core portion 1001 electrically connected to a ground of the electronic device 101, and a first peripheral portion 1002 surrounding the first core portion 1001. The first set of conductive patterns 1020 may be disposed on the first peripheral portion 1002. The second sub link part 1100 may include a second core portion 1101 contacted with the first core portion 1001, and a second peripheral portion 1102 surrounding the second core portion 1101. The second set of conductive patterns 1120 may be disposed on the second peripheral portion 1102. For example, a portion of the first peripheral portion 1002 may be defined by the first set of conductive patterns 1020, and a portion of the second peripheral portion 1102 may be defined by the second set of conductive patterns 1120.

According to an embodiment, the first set of conductive patterns 1020 may include a first conductive pattern 1021 defining a first region 1041 of the first peripheral portion 1002. The first set of conductive patterns 1020 may include a second conductive pattern 1022 defining a second region 1042 of the first peripheral portion 1002 spaced apart from the first region 1041 of the first peripheral portion 1002. The second set of conductive patterns 1120 may include a third conductive pattern 1121, contacted with the first conductive pattern 1021, defining a third region 1043 of the second peripheral portion 1102 contacted with the first region 1041 of the first peripheral portion 1002. The second set of conductive patterns 1120 may include a fourth conductive pattern 1122, contacted with the second conductive pattern 1022, defining a fourth region 1141 of the second peripheral portion 1102, wherein the fourth region 1141 is spaced apart from the third region 1043 of the second peripheral portion 1102 and is contacted with the second region 1042 of the first peripheral portion 1102.

According to an embodiment, each conductive pattern of the second set of conductive patterns 1120 may be contacted with the corresponding conductive pattern of the first set of conductive patterns 1020, when the second sub link part 1100 is coupled to the first sub link part 1000. Each conductive pattern of the second set of conductive patterns 1120 may be configured to be electrically connected to each corresponding conductive pattern of the first set of conductive patterns 1020, by maintaining contact with the corresponding conductive pattern of the first set of conductive patterns 1020, when the first sub link part 1000 or the second sub link part 1100 is rotated in accordance with movement of the first housing part 210 or the second housing part 220.

According to an embodiment, at least one link part among the one or more link parts 630 may be configured to move in accordance with the movement of the first housing part 210 or the second housing part 220. The electronic device 101 may include a guide groove 1810 into which at least one link part among the one or more link parts 630 is inserted, configured to guide the movement of the at least one link part.

The effects that can be obtained from the present disclosure are not limited to those described above, and any other effects not mentioned herein will be clearly understood by those having ordinary knowledge in the art to which the present disclosure belongs, from the following description.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device comprising:
a housing including a first housing part and a second housing part movably coupled to each other,
a first printed circuit board, PCB, disposed in the first housing part;
a second PCB disposed in the second housing part; and
a flexible printed circuit board, FPCB, assembly configured to electrically connect the first PCB and the second PCB,
wherein the FPCB assembly includes:
a first PCB comprising a first set of signal lines for transmitting a plurality of signals,
a second PCB comprising a second set of signal lines for transmitting the plurality of signals, and
at least one link part rotatably connecting the first PCB and the second PCB,
wherein the at least one link part comprises a first sub link part and a second sub link part rotatably coupled to each other,
wherein the first sub link part comprises a first set of conductive patterns, each conductive pattern of the first set of conductive patterns electrically connected to a respective signal line of the first set of signal lines,
wherein the second sub link part comprises a second set of conductive patterns, each conductive pattern of the second set of conductive patterns electrically connected to a respective signal line of the second set of signal lines, and
wherein each conductive pattern of the first set of conductive patterns is configured to be electrically connected to a respective conductive pattern of the second set of conductive patterns.

2. The electronic device of claim 1,
wherein the first PCB, the second PCB, the first PCB of the FPCB assembly, and the second PCB of the FPCB assembly are disposed substantially parallel to each other.

3. The electronic device of claim 1 or claim 2, further comprising:
wireless communication circuitry disposed on the first PCB; and
one or more antenna radiator electrically connected to the second PCB,
wherein the FPCB assembly is configured to transmit radio frequency, RF, signals from the wireless communication circuitry disposed on the first PCB to the one or more antenna radiator electrically connected to the second PCB, through the first set of signal lines and the second set of signal lines.

4. The electronic device of claim 3,
wherein the one or more antenna radiator defines at least a portion of a periphery of the second housing part.

5. The electronic device of any preceding claim,
wherein the first sub link part or the second sub link part is configured to rotate in accordance with movement of the first housing part or the second housing part.

6. The electronic device of claim 5, wherein, when the second sub link part is coupled to the first sub link part, each conductive pattern of the second set of conductive patterns is configured to contact the respective conductive pattern of the first set of conductive patterns to electrically connect the first set and second set of conductive patterns.

7. The electronic device of claim 6, wherein a length of each conductive pattern of each of the second set of conductive patterns is longer than the length of each respective conductive pattern of the first set of conductive patterns to which it is electrically connected, such that the contact is maintained with the corresponding conductive pattern of the first set of conductive patterns when the first sub link part or the second sub link part is rotated in accordance with movement of the first housing part or the second housing part.

8. The electronic device of any preceding claim,
wherein the first sub link part includes:
a first core portion electrically connected to a ground of the electronic device, and
a first peripheral portion, surrounding the first core portion, on which the first set of conductive patterns is disposed, and
wherein the second sub link part includes:
a second core portion contacted with the first core portion of the first sub link part, and
a second peripheral portion, surrounding the second core portion, on which the second set of conductive patterns is disposed.

9. The electronic device of claim 8,
wherein the first set of conductive patterns includes:
a first conductive pattern defining a first region of the first peripheral portion, and
a second conductive pattern defining a second region of the first peripheral portion spaced apart from the first region of the first peripheral portion, and
wherein the second set of conductive patterns includes:
a third conductive pattern, contacted with the first conductive pattern, defining a third region of the second peripheral portion contacted with the first region of the first peripheral portion, and
a fourth conductive pattern, contacted with the second conductive pattern, defining a fourth region of the second peripheral portion, wherein the fourth region is spaced apart from the third region of the second peripheral portion and is contacted with the second region of the first peripheral portion, and
wherein a first circumference of the first region is shorter than a third circumference of the third region, and
wherein a second circumference of the second region is shorter than a fourth circumference of the fourth region.

10. The electronic device of any preceding claim,
wherein the first set of signal lines includes:
a first signal line to transmit a first RF signal on a first frequency band, and
a second signal line to transmit a second RF signal on a second frequency band different from the first frequency band,
wherein the second set of signal lines includes:
a third signal line to transmit the first RF signal, and
a fourth signal line to transmit the second RF signal,
wherein the first set of conductive patterns includes:
a first conductive pattern electrically connected to the first signal line, and
a second conductive pattern electrically connected to the second signal line, and
wherein the second set of conductive patterns includes:
a third conductive pattern electrically connected to the third signal line and the first conductive pattern, and
a fourth conductive pattern electrically connected to the fourth signal line and the second conductive pattern.

11. The electronic device of any preceding claim,
wherein at least one link part is configured to move in accordance with movement of the first housing part or the second housing part, and
wherein the electronic device comprises a guide groove, into which at least one link part is inserted, configured to guide the movement of the at least one link part.

12. The electronic device of any preceding claim,
wherein the at least one link part includes a stopper to limit an amount of rotation of the at least one link part.

13. The electronic device of any preceding claim,
wherein the first sub link part includes:
a first core portion electrically connected to a ground of the electronic device,
a first conductive pattern, spaced apart from the first core portion, surrounding the first core portion, and
a second conductive pattern, spaced apart from the first conductive pattern, surrounding the first conductive pattern, and
wherein the second sub link part includes:
a second core portion electrically connected to a ground of the electronic device,
a third conductive pattern, spaced apart from the second core portion, surrounding the second core portion, and electrically connected to the first conductive pattern, and
a fourth conductive pattern, spaced apart from the third conductive portion, surrounding the third conductive pattern, and electrically connected to the second conductive pattern.

14. The electronic device of any preceding claim, further comprising a driving mechanism, configured to move the first housing part or the second housing part, including:
a motor,
a pinion gear coupled to a rotation axis of the motor, and
a rack gear engaged with the pinion gear, coupled to the first housing part or the second housing part,
wherein the first PCB of the FPCB assembly and the second PCB of the FPCB assembly are disposed parallel to the rack gear.

15. The electronic device of any preceding claim,
wherein the FPCB assembly further includes:
a third FPCB connected to the first PCB and rotatably connected to the first PCB of the FPCB assembly, and
a fourth FPCB connected to the second PCB and rotatably connected to the second PCB of the FPCB assembly, and
wherein the at least one link part includes a first link part rotatably connecting an end portion of the first PCB of the FPCB assembly and an end portion of the second PCB of the FPCB assembly, and
wherein the FPCB assembly further includes:
a second link part rotatably connecting another end portion of the first PCB of the FPCB assembly and an end portion of the third FPCB, and
a third link part rotatably connecting another end portion of the second PCB of the FPCB assembly and an end portion of the fourth FPCB.
